# EUROPEAN PATENT APPLICATION

(11) **EP 4 773 777 A1**
(43) Date of publication of application: **08.07.2026**
(21) Application number: 24882746.1
(22) Date of filing: 18.10.2024
(51) Int. Cl.: H10K 59/131, H10K 77/10, G09F 9/30, G06F 1/16, H10K 59/35, G09G 3/3233, H10K 59/60

(54) **DISPLAY DEVICE**

(30) Priority: 24.10.2023 KR 20230143248
(71) Applicant: Samsung Display Co., Ltd., Yongin-si, Gyeonggi-do 17113 (KR)
(72) Inventor: LEE, Hyun Sup, Yongin-si Gyeonggi-do 17113 (KR); KIM, Seong Won, Yongin-si Gyeonggi-do 17113 (KR)
(74) Representative: Walaski, Jan Filip
(86) International application number: PCT/KR2024/015911
(87) International publication number: WO 2025/089719

(57) **Abstract**

A display apparatus includes a substrate including base portions arranged in a first direction and a second direction, a first bridge portion connecting the base portions arranged in the first direction, a second bridge portion connecting the base portions arranged in the second direction, openings located between the base portions, and sub-islands protruding from the base portions, a first wiring located on the first bridge portion, a second wiring located on the second bridge portion, and a light-emitting element located on each of the sub-islands.

## Description

### Technical Field

One or more embodiments relate to a display apparatus, for example, a flexible display apparatus.

### Background Art

As display apparatuses that visually display electrical signals have been developed, various display apparatuses having excellent characteristics such as thin design, light weight, and low power consumption have been introduced. For example, flexible display apparatuses that may be folded or rolled up have been introduced. Recently, research and development on display apparatuses having various structures such as stretchable display apparatuses that may be changed into various shapes have been actively conducted.

### Disclosure of Invention

### Technical Problem

One or more embodiments include a display apparatus, for example, a flexible display apparatus.

### Solution to Problem

According to one or more embodiments, a display apparatus includes a substrate including base portions arranged in a first direction and a second direction, a first bridge portion connecting the base portions arranged in the first direction, a second bridge portion connecting the base portions arranged in the second direction, openings located between the base portions, and sub-islands protruding from the base portions, a first wiring located on the first bridge portion, a second wiring located on the second bridge portion, and a light-emitting element located on each of the sub-islands.

### Advantageous Effects of Invention

According to an embodiment, a display apparatus that may prevent damage due to concentration of stress and may be stretched in various directions may be provided. These effects are examples, and do not limit the scope of the disclosure.

### Brief Description of Drawings

FIG. 1 is a perspective view schematically illustrating a display apparatus, according to an embodiment.
FIGS. 2A and 2B are perspective views illustrating a state where the display apparatus of FIG. 1 is stretched in a first direction.
FIG. 2C is a perspective view illustrating a state where the display apparatus of FIG. 1 is stretched in a second direction.
FIG. 2D is a perspective view illustrating a state where the display apparatus of FIG. 1 is stretched in the first direction and the second direction.
FIG. 2E is a perspective view illustrating a state where the display apparatus of FIG. 1 is stretched in a third direction.
FIG. 3 is a plan view schematically illustrating a display apparatus, according to an embodiment.
FIG. 4A is an enlarged plan view illustrating a portion IV of the display apparatus of FIG. 3, according to an embodiment.
FIG. 4B is an enlarged plan view illustrating a portion IV of the display apparatus of FIG. 3, according to an embodiment.
FIG. 4C is an enlarged plan view illustrating a portion IV of the display apparatus of FIG. 3, according to an embodiment.
FIG. 5 is a cross-sectional view schematically illustrating a first island portion and a first bridge portion located in a display area of a display apparatus, according to an embodiment.
FIGS. 6A to 6C are equivalent circuit diagrams illustrating a sub-pixel of a display apparatus, according to an embodiment.
FIGS. 7A and 7B are cross-sectional views schematically illustrating a light-emitting element of a display apparatus, according to an embodiment.
FIG. 8 is a plan view illustrating a part of a display area of a display apparatus, according to an embodiment.
FIG. 9 is an enlarged plan view illustrating shapes of a bridge portion and a sub-island of a substrate applicable to a display apparatus, according to an embodiment.
FIG. 10A is a plan view illustrating a part of a display area of a display apparatus, according to an embodiment.
FIG. 10B is a plan view illustrating a part of a display area of a display apparatus, according to an embodiment.
FIG. 11 is a plan view schematically illustrating a pixel arrangement or light-emitting element arrangement structure of a display apparatus, according to an embodiment.
FIG. 12A is a plan view schematically illustrating an arrangement of pixel driving circuit units and an arrangement of wirings of a display apparatus, according to embodiments.
FIG. 12B is a plan view schematically illustrating an arrangement of pixel driving circuit units and an arrangement of wirings of a display apparatus, according to embodiments.
FIG. 13A is a plan view schematically illustrating a pixel arrangement or light-emitting element arrangement structure of a display apparatus, according to an embodiment.
FIG. 13B is a plan view schematically illustrating a pixel arrangement or light-emitting element arrangement structure of a display apparatus, according to an embodiment.
FIGS. 14A to 14G are perspective views schematically illustrating embodiments of an electronic device including a display apparatus, according to an embodiment.

### Best Mode for Carrying out the Invention

According to one or more embodiments, a display apparatus includes a substrate including base portions arranged in a first direction and a second direction, a first bridge portion connecting the base portions arranged in the first direction, a second bridge portion connecting the base portions arranged in the second direction, openings located between the base portions, and sub-islands protruding from the base portions, a first wiring located on the first bridge portion, a second wiring located on the second bridge portion, and a light-emitting element located on each of the sub-islands.

An area of one of the sub-islands may be less than an area of one of the base portions.

Each of the first bridge portion and the second bridge portion may have an S shape.

The first bridge portion may include a first portion convex in one direction in a plan view and a second portion convex in a direction opposite to the first portion, wherein an outer side of a first sub-island from among the sub-islands has a radius of curvature corresponding to the first portion.

The sub-islands may be connected to one base portion and may include a first sub-island, a second sub-island, a third sub-island, and a fourth sub-island which are spaced apart from each other, wherein a first sub-pixel is located on the first sub-island, a second sub-pixel is located on the second sub-island, and a third sub-pixel is located on the third sub-island, wherein the first sub-pixel, the second sub-pixel, and the third sub-pixel emit light of different colors.

The display apparatus may further include a first pixel driving circuit unit located on the base portion to drive the first sub-pixel, a second pixel driving circuit unit located on the base portion to drive the second sub-pixel, and a third pixel driving circuit unit located on the base portion to drive the third sub-pixel.

The display apparatus may further include a first pixel driving circuit unit located on the first sub-island, a second pixel driving circuit unit located on the second sub-island, and a third pixel driving circuit unit located on the third sub-island.

A fourth sub-pixel may be located on the fourth sub-island, and the fourth sub-pixel may emit light of a same color as one of the first sub-pixel, the second sub-pixel, and the third sub-pixel.

A sensor may be located on the fourth sub-island, and the sensor may be a light sensor.

The first wiring and the second wiring may intersect each other in the base portion.

According to one or more embodiments, a display apparatus includes a substrate including a base portion, bridge portions connected to the base portion, sub-islands, and an opening located around the sub-islands, wirings located on the bridge portions, and light-emitting elements located on the sub-islands, wherein the bridge portions and the sub-islands surround an outer side of the base portion and are alternately connected to each other.

The bridge portions may include a first bridge portion extending in a first direction and a second bridge portion in a second direction.

A first wiring may be located on the first bridge portion, and a second wiring may be located on the second bridge portion, wherein the first wiring and the second wiring intersect each other in the base portion.

An area of one of the sub-islands may be less than an area of one of the base portions.

Each of the bridge portions may have an S shape.

The sub-islands may be connected to one base portion and may include a first sub-island, a second sub-island, a third sub-island, and a fourth sub-island which are spaced apart from each other, wherein a first sub-pixel is located on the first sub-island, a second sub-pixel is located on the second sub-island, and a third sub-pixel is located on the third sub-island, wherein the first sub-pixel, the second sub-pixel, and the third sub-pixel emit light of different colors.

The display apparatus may further include a first pixel driving circuit unit located on the base portion to drive the first sub-pixel, a second pixel driving circuit unit located on the base portion to drive the second sub-pixel, and a third pixel driving circuit unit located on the base portion to drive the third sub-pixel.

The display apparatus may further include a first pixel driving circuit unit located on the first sub-island, a second pixel driving circuit unit located on the second sub-island, and a third pixel driving circuit unit located on the third sub-island.

A fourth sub-pixel may be located on the fourth sub-island, and the fourth sub-pixel may emit light of a same color as one of the first sub-pixel, the second sub-pixel, and the third sub-pixel.

A sensor may be located on the fourth sub-island, and the sensor may be a light sensor.

### Mode for the Invention

As the disclosure allows for various changes and numerous embodiments, certain embodiments will be illustrated in the drawings and described in the detailed description. Effects and features of the disclosure, and methods for achieving them will be clarified with reference to embodiments described below in detail with reference to the drawings. However, the disclosure is not limited to the following embodiments and may be embodied in various forms.

Hereinafter, embodiments will be described in detail with reference to the accompanying drawings, wherein the same or corresponding elements are denoted by the same reference numerals throughout and a repeated description thereof is omitted.

Although the terms "first," "second," etc. may be used to describe various elements, these elements should not be limited by these terms. These terms are only used to distinguish one element from another.

As used herein, the singular forms "a," "an," and "the" are intended to include the plural forms as well, unless the context clearly indicates otherwise.

It will be understood that the terms "including," and "having," are intended to indicate the existence of the features or elements described in the specification, and are not intended to preclude the possibility that one or more other features or elements may exist or may be added.

It will be further understood that, when a layer, region, or component is referred to as being "on" another layer, region, or component, it may be directly on the other layer, region, or component, or may be indirectly on the other layer, region, or component with intervening layers, regions, or components therebetween.

Sizes of components in the drawings may be exaggerated or reduced for convenience of explanation. For example, because sizes and thicknesses of elements in the drawings are arbitrarily illustrated for convenience of explanation, the disclosure is not limited thereto.

When a certain embodiment may be implemented differently, a specific process order may be different from the described order. For example, two consecutively described processes may be performed substantially at the same time or may be performed in an order opposite to the described order.

"A and/or B" is used herein to select only A, select only B, or select both A and B. "At least one of A or B" is used to select only A, select only B, or select both A and B.

It will be understood that when a layer, a region, or a component is referred to as being "connected" to another layer, region, or component, it may be "directly connected" to the other layer, region, or component and/or may be "indirectly connected" to the other layer, region, or component with other layers, regions, or components interposed therebetween. For example, when a layer, a region, or a component is referred to as being "electrically connected," it may be directly electrically connected, and/or may be indirectly electrically connected with intervening layers, regions, or components therebetween.

The x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

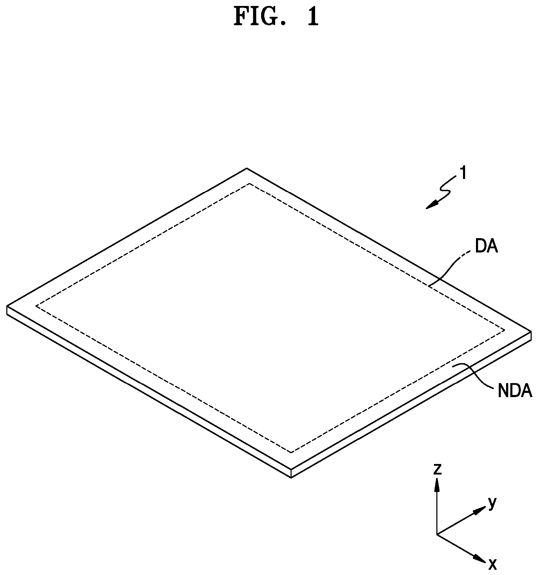

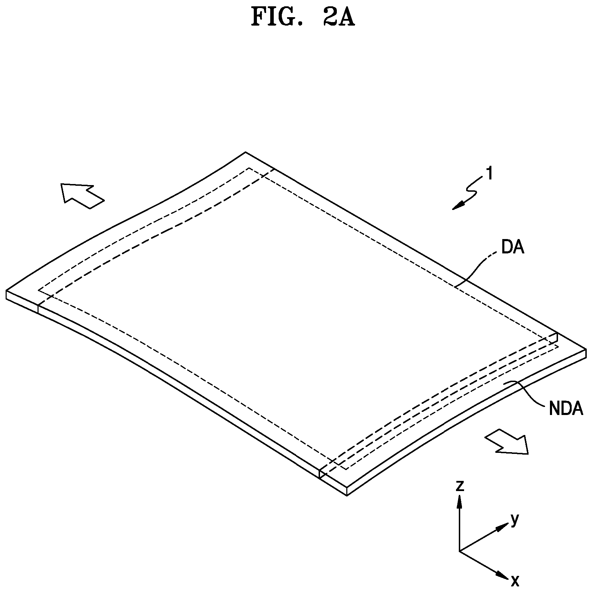

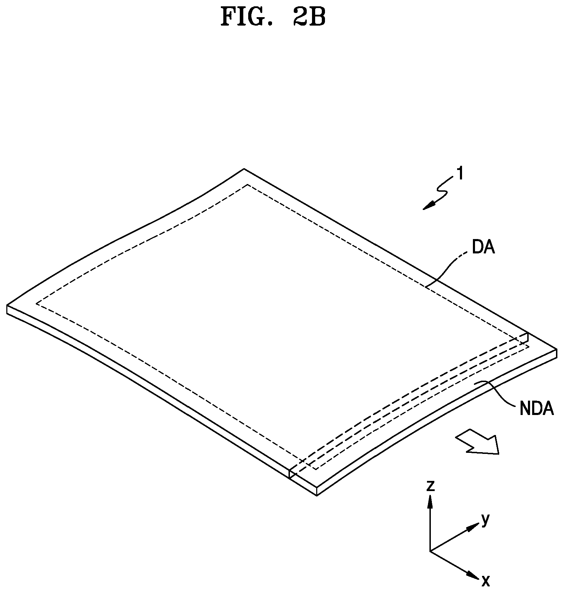

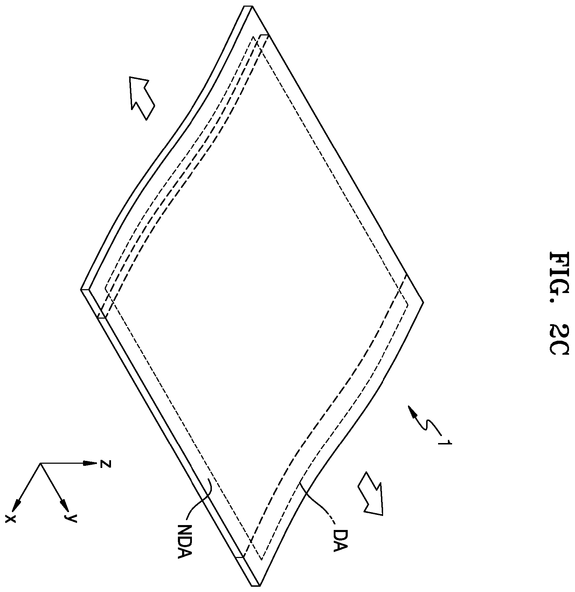

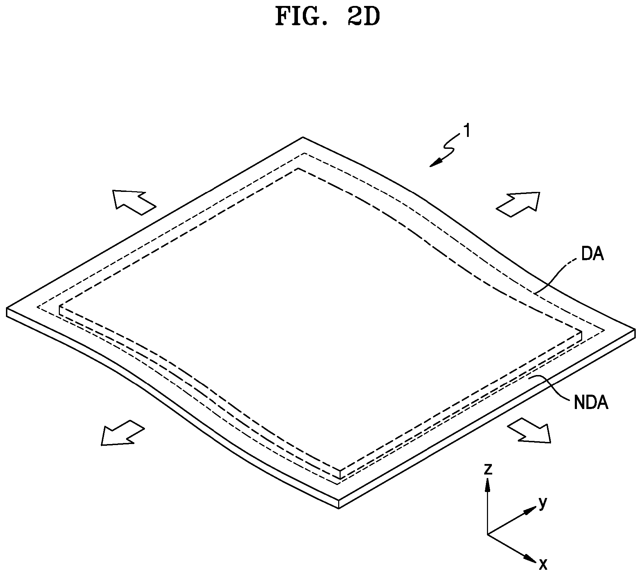

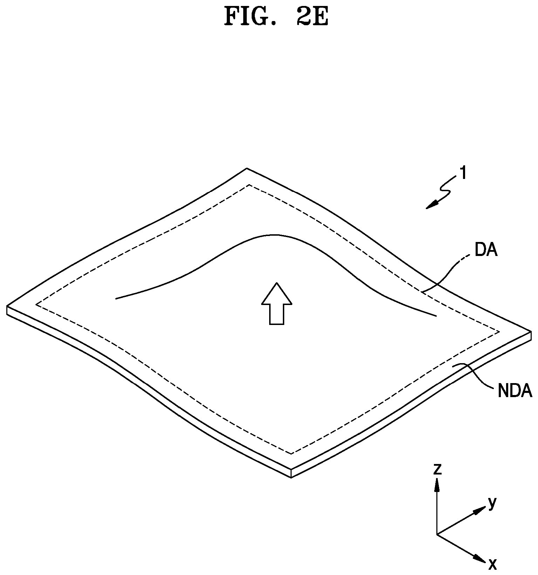

FIG. 1 is a perspective view schematically illustrating a display apparatus 1, according to an embodiment. FIGS. 2A and 2B are perspective views illustrating a state where the display apparatus 1 of FIG. 1 is stretched in a first direction. FIG. 2C is a perspective view illustrating a state where the display apparatus 1 of FIG. 1 is stretched in a second direction. FIG. 2D is a perspective view illustrating a state where the display apparatus of FIG. 1 is stretched in the first direction and the second direction. FIG. 2E is a perspective view illustrating a state where the display apparatus 1 of FIG. 1 is stretched in a third direction.

Referring to FIG. 1, the display apparatus 1 may include a display area DA and a non-display area NDA. The display area DA may include a plurality of pixels. The display apparatus 1 may provide a certain image by using light emitted from the plurality of pixels. The non-display area NDA may be located outside the display area DA. The non-display area NDA where pixels are not located may entirely surround the display area DA.

The display apparatus 1 may be stretched or shrunk in various directions. The display apparatus 1 may be stretched in a first direction (e.g., an x direction and/or a -x direction) by an external force applied by a user or an external object. In an embodiment, as shown in FIGS. 2A and 2B, the display area DA and/or the non-display area NDA of the display apparatus 1 may be stretched in the first direction (e.g., the x direction and/or the -x direction). For example, the display area DA and/or the non-display area NDA of the display apparatus 1 may be stretched along the x direction and the -x direction as shown in FIG. 2A, or may be stretched along the x direction with one side fixed as shown in FIG. 2B.

The display apparatus 1 may be stretched in a second direction (e.g., a y direction and/or a -y direction) by an external force applied by a user or an external object. In an embodiment, the display area DA and/or the non-display area NDA of the display apparatus 1 may be stretched in the y direction and the -y direction as shown in FIG. 2C. In another embodiment, the display area DA and/or the non-display area NDA of the display apparatus 1 may be stretched in the y direction or the -y direction with one side fixed.

The display apparatus 1 may be stretched in a plurality of directions, for example, in the first direction (e.g., the x direction and/or the -x direction) and the second direction (e.g., the y direction and/or the -y direction) by an external force applied by a user or an external object. The display area DA and/or the non-display area NDA of the display apparatus 1 may be stretched in the ±x direction and the ±y direction as shown in FIG. 2D.

The display apparatus 1 may be stretched in a third direction (e.g., a z direction or a -z direction) by an external force applied by a person's body part or an external object. In an embodiment, in FIG. 2E, a part of the display apparatus 1, for example, a portion of the display area DA, protrudes in the z direction. In another embodiment, a part of the display apparatus 1, for example, a portion of the display area DA, may protrude along the -z direction (or be recessed along the z direction).

Although the display apparatus 1 is stretched in the first direction, the second direction, and/or the third direction in FIGS. 2A to 2E, the disclosure is not limited thereto. In another embodiment, the display apparatus 1 may be deformed, for example, bent or twisted, into various irregular shapes along two or more axes.

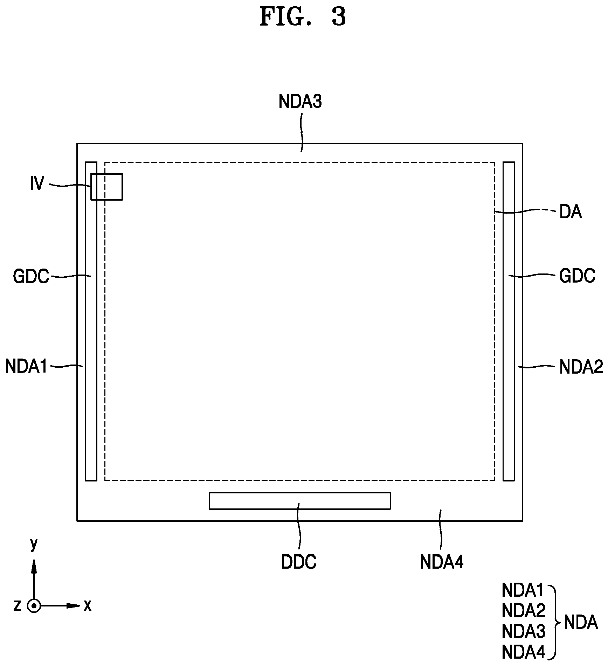

FIG. 3 is a plan view schematically illustrating the display apparatus 1, according to an embodiment.

A plurality of pixels may be arranged in the display area DA of the display apparatus 1. Each pixel may include sub-pixels emitting light of different colors. A light-emitting element corresponding to each sub-pixel may be located in the display area DA. A circuit for applying electrical signals to the light-emitting elements located in the display area DA and transistors electrically connected to the light-emitting elements may be located in the non-display area NDA around the display area DA. A gate driving circuit GDC may be located in a first non-display area NDA1 and a second non-display area NDA2 located on both sides of the display area DA. The gate driving circuit GDC may include drivers for applying electrical signals to gate electrodes of the transistors electrically connected to the light-emitting elements. Although the gate driving circuit GDC is located in each of the first non-display area NDA1 and the second non-display area NDA2 in FIG. 3, the disclosure is not limited thereto. In another embodiment, the gate driving circuit GDC may be located in any one of the first non-display area NDA1 and the second non-display area NDA2.

A data driving circuit DDC may be located in a third non-display area NDA3 and/or a fourth non-display area NDA4 connecting the first non-display area NDA1 to the second non-display area NDA2. In an embodiment, in FIG. 3, the data driving circuit DDC is located in the fourth non-display area NDA4. In another embodiment, the data driving circuit DDC may be located in each of the third non-display area NDA3 and the fourth non-display area NDA4.

Although the data driving circuit DDC is located in the fourth non-display area NDA4 of the display apparatus 1 in FIG. 3, the disclosure is not limited thereto. In another embodiment, the display apparatus 1 may further include a flexible circuit board (not shown) electrically connected through a terminal unit (not shown) located in the fourth non-display area NDA4, and the data driving circuit DDC may be located on the flexible circuit board.

In some embodiments, an elongation rate of the non-display area NDA may be equal to or less than an elongation rate of the display area DA. In an embodiment, an elongation rate of the non-display area NDA may be different for each area. For example, the first non-display area NDA1, the second non-display area NDA2, and the third non-display area NDA3 may have substantially the same elongation rate, but an elongation rate of the fourth non-display area NDA4 may be less than that of each of the first non-display area NDA1, the second non-display area NDA2, and the third non-display area NDA3.

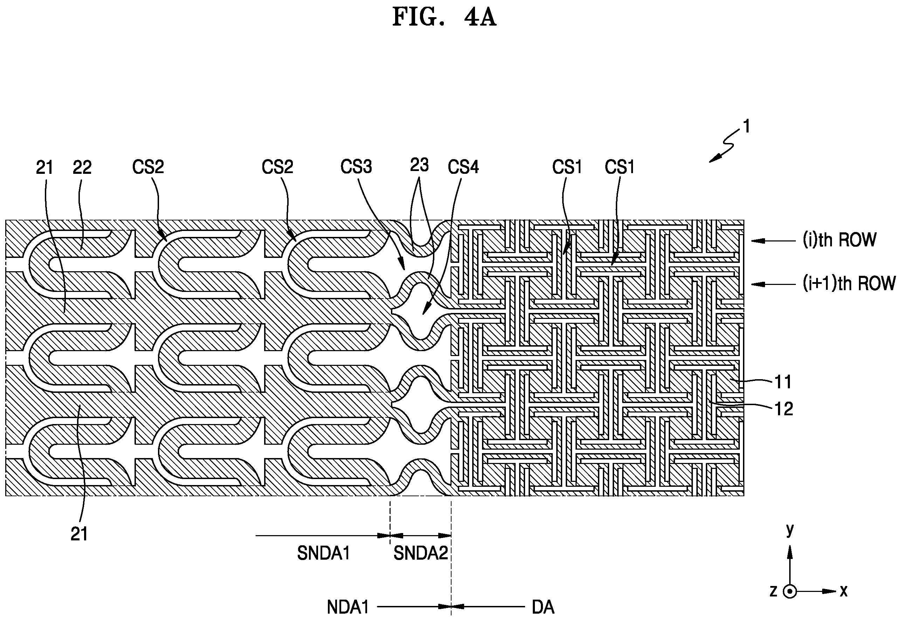

FIG. 4A is an enlarged plan view illustrating a portion IV of the display apparatus 1 of FIG. 3, according to an embodiment.

Referring to FIG. 4A, the display apparatus 1 may include first island portions 11 that are spaced apart from each other in the first direction (e.g., the x direction or the -x direction) and the second direction (e.g., the y direction or the -y direction), and first bridge portions 12 connecting adjacent first island portions 11.

Each first island portion 11 may be connected to a plurality of first bridge portions 12. For example, each first island portion 11 may be connected to four first bridge portions 12. Two first bridge portions 12 may be located on both sides of the first island portion 11 along the first direction (e.g., the x direction or the -x direction), and the remaining two first bridge portions 12 may be located on both sides of the first island portion 11 along the second direction (e.g., the y direction or the -y direction). In an embodiment, the four first bridge portions 12 may be respectively connected to four sides of the first island portion 11. Each of the four first bridge portions 12 may be adjacent to each of corners of the first island portion 11.

The first bridge portions 12 may be spaced apart from each other by a first opening CS1 located between the first bridge portions 12. In an embodiment, a first opening CS1 having a substantially H shape and a first opening CS1 having a substantially I shape obtained by rotating the H shape by 90 degrees may be alternately and repeatedly arranged along the first direction (e.g., the x direction or the -x direction) and the second direction (e.g., the y direction or the -y direction). Both ends of each first bridge portion 12 may be respectively connected to adjacent first island portions 11, and one side of each first bridge portion 12 may be spaced apart from one side of the adjacent first island portion 11 and/or one side of another first bridge portion 12 by the first opening CS1.

The display apparatus 1 may include second island portions 21 spaced apart from each other and second bridge portions 22 connecting adjacent second island portions 21 in the non-display area, for example, the first non-display area NDA1 of FIG. 4A.

Each second island portion 21 may extend along the first direction (e.g., the x direction or the -x direction). The second island portions 21 may be spaced apart from each other along the second direction (e.g., the y direction or the -y direction) intersecting the first direction (e.g., the x direction or the -x direction). Each second island portion 21 may include drivers of the gate driving circuit GDC (see FIG. 2) described with reference to FIG. 3.

The second bridge portion 22 may have a serpentine shape. A length of the second bridge portion 22 may be greater than a shortest distance between the second island portions 21 adjacent to each other along the second direction (e.g., the y direction or the -y direction). In an embodiment, the second bridge portion 22 may have a substantially omega (Ω) shape convex toward the first direction (e.g., the x direction or the -x direction). The second bridge portions 22 may be located between adjacent second island portions 21 and may be spaced apart from each other.

The second bridge portions 22 between adjacent second island portions 21 may be spaced apart from each other by a second opening CS2. Between adjacent second island portions 21, the second openings CS2 and the second bridge portions 22 may be alternately arranged along the first direction (e.g., the x direction or the -x direction). The second openings CS2 may have the same shape. Both ends of each second bridge portion 22 may be respectively connected to adjacent second island portions 21, and one side of each second bridge portion 22 may be spaced apart from one side of the adjacent second island portion 21 and/or one side of another second bridge portion 22 by the second opening CS2.

Any one second island portion 21 located in the first non-display area NDA1 my correspond to the first island portions 11 of a plurality of rows arranged in the display area DA. For example, any one second island portion 21 located in the first non-display area NDA1 may correspond to the first island portions 11 arranged in an (i)^{th} row and the first island portions 11 arranged in an (i+1)^{th} row in the display area DA (where i is a positive number greater than 0). Although one second island portion 21 corresponds to two rows of the first island portions 11 in FIG. 4A, the disclosure is not limited thereto. In another embodiment, any one second island portion 21 located in the first non-display area NDA1 may correspond to n rows of the first island portions 11 located in the display area DA (where n is a positive number of 3 or more).

The non-display area, for example, the first non-display area NDA1, may include a first sub-non-display area SNDA1 in which the second island portions 21 and the second bridge portions 22 are located, and a second sub-non-display area SNDA2 between the first sub-non-display area SNDA1 and the display area DA. Third bridge portions 23 for connecting the display area DA to the first sub-non-display area SNDA1 may be located in the second sub-non-display area SNDA2. One end of the third bridge portion 23 may be connected to the second island portion 21 and/or the second bridge portion 22, and the other end of the third bridge portion 23 may be connected to the first island portion 11 and/or the first bridge portion 12.

The third bridge portion 23 may have a serpentine shape. In an embodiment, a shape of the third bridge portion 23 may be different from a shape of each of the first bridge portion 12 and the second bridge portion 22. In an embodiment, as shown in FIG. 4A, the third bridge portion 23 may have a substantially omega (Ω) shape convex toward the second direction (e.g., the y direction or the -y direction). Adjacent third bridge portions 23 arranged along the second direction (e.g., the y direction or the -y direction) may have a symmetrical structure in which one of the adjacent third bridge portions 23 is convex in the y direction and the other is convex in the -y direction. A third opening CS3 and a fourth opening CS4 having different shapes may be repeatedly provided between the third bridge portions 23. A width of the third bridge portion 23 may be different from a width of the first bridge portion 12 and a width of the second bridge portion 22. In an embodiment, a width of the third bridge portion 23 may be greater than a width of the first bridge portion 12 and may be less than a width of the second bridge portion 22.

In FIG. 4A, the second island portion 21 and the second bridge portion 22 of the non-display area, for example, the first non-display area NDA1, have different shapes from the first island portion 11 and the first bridge portion 12 of the display area DA. In another embodiment, the second island portion 21 and the second bridge portion 22 of the non-display area may have the same shape as the first island portion 11 and the first bridge portion 12 of the display area DA, respectively.

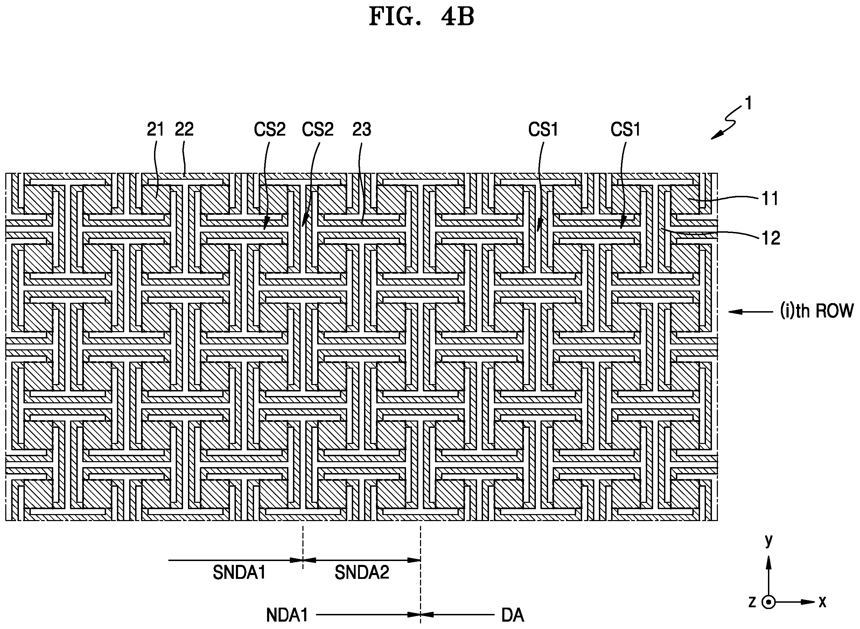

FIG. 4B is an enlarged plan view illustrating a portion IV of the display apparatus 1 of FIG. 3, according to an embodiment.

Referring to FIG. 4B, the display apparatus 1 includes the first island portions 11 spaced apart from each other in the display area DA and the first bridge portions 12 spaced apart from each other by the first opening CS1 and connecting adjacent first island portions 11. A structure of the display area DA of FIG. 4B may be the same as a structure of the display area DA described with reference to FIG. 4A.

The display apparatus 1 may include the second island portions 21 and the second bridge portions 22. In an embodiment, the second island portions 21 and the second bridge portions 22 may have substantially the same shape as the first island portions 11 and the first bridge portions 12, respectively.

The second island portions 21 may be spaced apart from each other in the first direction (e.g., the x direction or the -x direction) and the second direction (e.g., the y direction or the -y direction) in the non-display area, for example, the first non-display area NDA1. Each of the second bridge portions 22 may connect adjacent second island portions 21. The second bridge portions 22 may be spaced apart from each other by the second opening CS2 located between the second bridge portions 22.

The second opening CS2 may have substantially the same shape as the first opening CS1. For example, the second opening CS2 having a substantially H shape and the second opening CS2 having a substantially I shape may be alternately and repeatedly arranged in the non-display area, for example, the first non-display area NDA1. Both ends of each second bridge portion 22 may be respectively connected to adjacent second island portions 21, and one side of each second bridge portion 22 may be spaced apart from one side of the adjacent second island portion 21 and/or one side of another second bridge portion 22 by the second opening CS2.

Each second island portion 21 may be connected to four second bridge portions 22. Each second island portion 21 may include drivers of the gate driving circuit GDC (see FIG. 2) described with reference to FIG. 3.

The second island portions 21 of any one row located in the first non-display area NDA1 may correspond to the first island portions 11 of any one row arranged in the display area DA. For example, the second island portions 21 arranged in an (i)^{th} row along the first direction (e.g., the x direction or the -x direction) in the first non-display area NDA1 may correspond to the first island portions 11 arranged in the same row, for example, an (i)^{th} row, in the display area DA (where i is a positive number greater than 0).

The display apparatus 1 may include third bridge portions 23 located in the second sub-non-display area SNDA2 for connecting the display area DA to the first sub-non-display area SNDA1. The non-display area, for example, the first non-display area NDA1, may include the first sub-non-display area SNDA1 in which the second island portions 21 and the second bridge portions 22 are located, and the second sub-non-display area SNDA2 including the third bridge portions 23 and located between the first sub-non-display area SNDA1 and the display area DA. The third bridge portion 23 may be substantially the same as the first bridge portion 12 and the second bridge portion 22. For example, a width of the third bridge portion 23 may be the same as a width of the first bridge portion 12 and a width of the second bridge portion 22.

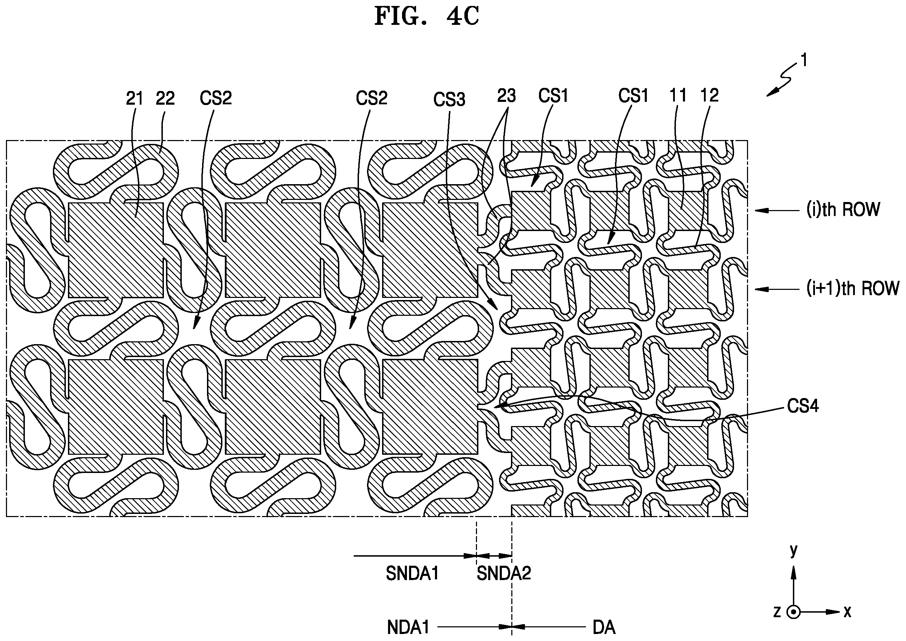

FIG. 4C is an enlarged plan view illustrating a portion IV of the display apparatus of FIG. 3, according to an embodiment.

Referring to FIG. 4C, the display apparatus 1 may include the first island portions 11 spaced apart from each other in the first direction (e.g., the x direction or the -x direction) and the second direction (e.g., the y direction or the -y direction) and the first bridge portions 12 connecting adjacent first island portions 11 in the display area DA.

The first bridge portions 12 may be spaced apart from each other by the first opening CS1 located between the first bridge portions 12. The first bridge portion 12 may have a serpentine shape. For example, as shown in FIG. 4C, the first bridge portion 12 may have a substantially 'letter S' shape.

Each first island portion 11 may be connected to a plurality of first bridge portions 12. For example, each first island portion 11 may be connected to four first bridge portions 12. Two first bridge portions 12 may be located on both sides of the first island portion 11 along the first direction (e.g., the x direction or the -x direction), and the remaining two first bridge portions 12 may be located on both sides of the first island portion 11 along the second direction (e.g., the y direction or the -y direction). The four first bridge portions 12 may be respectively connected to four sides of the first island portion 11. Each of the four first bridge portions 12 may be adjacent to each of corners of the first island portion 11.

The display apparatus 1 may include the second island portions 21 spaced apart from each other in the first direction (e.g., the x direction or the -x direction) and the second direction (e.g., the y direction or the -y direction) and the second bridge portions 22 connecting adjacent second island portions 21 in the non-display area, for example, the first non-display area NDA1 of FIG. 4C.

The second bridge portions 22 may be spaced apart from each other by the second opening CS2 located between the second bridge portions 22. The second bridge portion 22 may have a serpentine shape. For example, as shown in FIG. 4C, the second bridge portion 22 may have a substantially 'letter S' shape. A size and/or a width of the second bridge portion 22 may be different from a size and/or a width of the first bridge portion 12. For example, a size and/or a width of the second bridge portion 22 may be greater than a size and/or a width of the first bridge portion 12. A radius of curvature of a rounded portion of the second bridge portion 22 may be different from a radius of curvature of a rounded portion of the first bridge portion 12. For example, a radius of curvature of a rounded portion of the second bridge portion 22 may be greater than a radius of curvature of a rounded portion of the first bridge portion 12.

Each second island portion 21 may be connected to a plurality of second bridge portions 22. Each second island portion 21 may be connected to four second bridge portions 22. Two second bridge portions 22 may be located on both sides of the second island portion 21 along the first direction (e.g., the x direction or the -x direction), and the remaining two second bridge portions 22 may be located on both sides of the second island portion 21 along the second direction (e.g., the y direction or the -y direction). In an embodiment, the four second bridge portions 22 may be respectively connected to four sides of the second island portion 21. Each second bridge portion 22 may be connected to a central portion of each side of the second island portion 21.

The second island portions 21 of any one row located in the first non-display area NDA1 may correspond to the first island portions 11 of a plurality of rows arranged in the display area DA. For example, the second island portions 21 of any one row located in the first non-display area NDA1 may correspond to the first island portions 11 arranged in an (i)^{th} row and the first island portions 11 arranged in an (i+1)^{th} row of the display area DA (where i is a positive number greater than 0). In another embodiment, the second island portions 21 of any one row may correspond to n rows of the first island portions 11 (where n is a positive number of 3 or more).

The non-display area, for example, the first non-display area NDA1, may include the first sub-non-display area SNDA1 in which the second island portions 21 and the second bridge portions 22 are located, and the second sub-non-display area SNDA2 between the first sub-non-display area SNDA1 and the display area DA. The third bridge portions 23 for connecting the display area DA to the first sub-non-display area SNDA1 may be located in the second sub-non-display area SNDA2. One end of the third bridge portion 23 may be connected to the second island portion 21, and the other end of the third bridge portion 23 may be connected to the first island portion 11. For example, one end of the third bridge portion 23 may be connected to a central portion of one side of the second island portion 21, and the other end of the third bridge portion 23 may be connected to a central portion of one side of the first island portion 11.

The third bridge portion 23 may have a serpentine shape. In an embodiment, a shape of the third bridge portion 23 may be different from a shape of each of the first bridge portion 12 and the second bridge portion 22. A width of the third bridge portion 23 may be different from a width of the first bridge portion 12 and a width of the second bridge portion 22. A width of the third bridge portion 23 may be greater than a width of the first bridge portion 12 and may be less than a width of the second bridge portion 22. The third opening CS3 and the fourth opening CS4 having different shapes may be alternately located between the third bridge portions 23 in the second direction (e.g., the y direction or the -y direction).

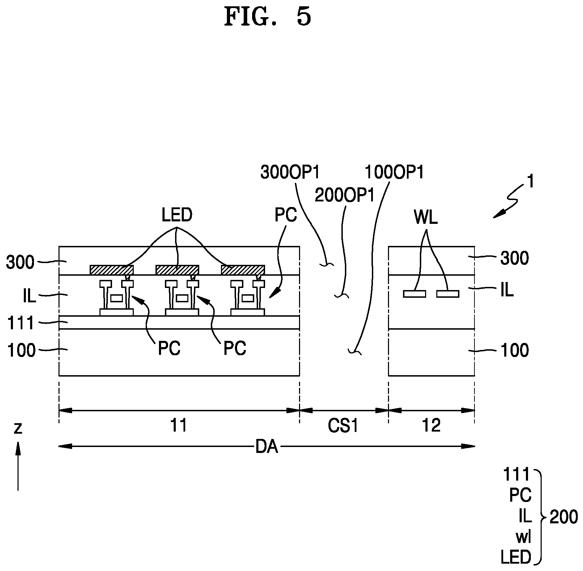

FIG. 5 is a cross-sectional view schematically illustrating the first island portion 11 and the first bridge portion 12 located in the display area DA of the display apparatus 1, according to an embodiment.

Referring to FIG. 5, the first island portion 11 and the first bridge portion 12 located in the display area DA may be spaced apart from each other with the first opening CS1 therebetween. The first island portion 11 may include light-emitting elements LED and a circuit, for example, a pixel driving circuit unit PC, electrically connected to each of the light-emitting elements LED to drive each of the light-emitting elements LED, and the first bridge portion 12 may include a wiring WL electrically connected to the pixel driving circuit units PC located in adjacent first island portions 11.

Regarding the first island portion 11, a buffer layer 111 including an inorganic insulating material may be located on a substrate 100, and the pixel driving circuit unit PC may be located on the buffer layer 111. An insulating layer IL including an inorganic insulating material and/or an organic insulating material may be located between the pixel driving circuit unit PC and the light-emitting element LED. The light-emitting element LED may be located on the insulating layer IL and may be electrically connected to the corresponding pixel driving circuit unit PC. The light-emitting elements LED may emit light of different colors or light of the same color. In an embodiment, the light-emitting elements LED may emit red light, green light, and blue light. In some embodiments, the light-emitting elements LED may emit white light. In another embodiment, the light-emitting elements LED respectively emit red light, green light, blue light, and white light.

The substrate 100 may include a polymer resin such as polyethersulfone, polyarylate, polyether imide, polyethylene naphthalate, polyethylene terephthalate, polyphenylene sulfide, polyimide, polycarbonate, cellulose triacetate, or cellulose acetate propionate. In an embodiment, the substrate 100 may have a single-layer structure including the polymer resin. In another embodiment, the substrate 100 may have a multi-layer structure including a base layer including the polymer resin and a barrier layer including an inorganic insulating material. The substrate 100 including the polymer resin may be flexible, rollable, or bendable.

In an embodiment, although three pixel driving circuit units PC are located in each first island portion 11 and three light-emitting elements LED are respectively connected to the pixel driving circuit units PC in FIG. 5, the disclosure is not limited thereto. In another embodiment, the number of pixel driving circuit units PC and light-emitting elements LED located in the first island portion 11 may be one, two, or four or more.

An encapsulation layer 300 may be located on the light-emitting element LED and may protect the light-emitting element LED from an external force and/or moisture penetration. The encapsulation layer 300 may include an inorganic encapsulation layer and/or an organic encapsulation layer. In some embodiments, the encapsulation layer 300 may have a structure in which an inorganic encapsulation layer including an inorganic insulating material, an organic encapsulation layer including an organic insulating material, and an inorganic encapsulation layer including an inorganic insulating material are stacked. In another embodiment, the encapsulation layer 300 may include an organic material such as resin. In some embodiments, the encapsulation layer 300 may include urethane epoxy acrylate. The encapsulation layer 300 may include a photosensitive material such as a photoresist.

Regarding the first bridge portion 12, the insulating layer IL including an organic insulating material may be located on the substrate 100. The first bridge portion 12 that is relatively highly deformed when the display apparatus 1 is stretched may not include a layer including an inorganic insulating material that is prone to cracks, unlike the first island portion 11.

In an embodiment, the substrate 100 corresponding to the first bridge portion 12 may have the same stacked structure as the substrate 100 corresponding to the first island portion 11. In an embodiment, the substrate 100 corresponding to the first bridge portion 12 and the substrate 100 corresponding to the first island portion 11 may be polymer resin layers formed together in the same process. In another embodiment, the substrate 100 corresponding to the first bridge portion 12 may have a stacked structure different from that of the substrate 100 corresponding to the first island portion 11. In some embodiments, the substrate 100 corresponding to the first island portion 11 may have a multi-layer structure including a base layer including a polymer resin and a barrier layer including an inorganic insulating material, and the substrate 100 corresponding to the first bridge portion 12 may have a structure including a polymer resin layer without a layer including an inorganic insulating material.

As described above, the wirings WL of the first bridge portion 12 may be signal lines (e.g., a gate line and a data line) for providing an electrical signal to a transistor included in the pixel driving circuit unit PC of the first island portion 11 or voltage lines (e.g., a driving voltage line and an initialization voltage line) for providing a voltage. The encapsulation layer 300 may also be located in the first bridge portion 12. In another embodiment, the encapsulation layer 300 may not be located in the first bridge portion 12.

Referring to FIGS. 4A to 4C and 5, the substrate 100 corresponding to the first island portion 11 and the substrate 100 corresponding to the first bridge portion 12 may be connected to each other. In other words, the plan view of FIGS. 4A to 4C may be substantially the same as a plan view of the substrate 100 of FIG. 5. In other words, the substrate 100 may include an area corresponding to the first island portion 11, an area corresponding to the first bridge portion 12, and an opening 100OP1 having the same shape as that of the first opening CS1.

Likewise, the encapsulation layer 300 corresponding to the first island portion 11 and the encapsulation layer 300 corresponding to the first bridge portion 12 may be connected to each other. For example, the plan view of FIGS. 4A to 4C may be substantially the same as a plan view of the encapsulation layer 300. In other words, the encapsulation layer 300 may include an area corresponding to the first island portion 11, an area corresponding to the first bridge portion 12, and an opening 300OP1 having the same shape as that of the first opening CS1.

A circuit-light-emitting element layer 200 between the substrate 100 and the encapsulation layer 300 may include the buffer layer 111, the pixel driving circuit unit PC, the wiring WL, the insulating layer IL, and the light-emitting element LED. Like the substrate 100, the plan view of FIGS. 4A to 4C may be substantially the same as a plan view of the circuit-light-emitting element layer 200. In other words, the circuit-light-emitting element layer 200 may include an opening 200OP1 having the same shape as that of the first opening CS1.

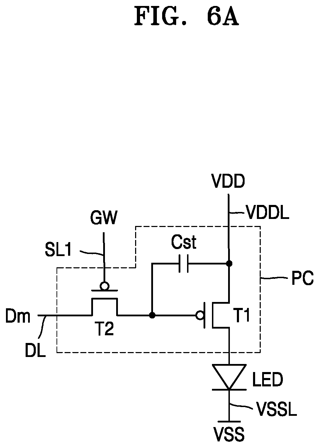

FIGS. 6A to 6C are equivalent circuit diagrams illustrating a sub-pixel of the display apparatus 1, according to an embodiment.

Referring to FIG. 6A, the light-emitting element LED corresponding to a sub-pixel may be electrically connected to the pixel driving circuit unit PC, and the pixel driving circuit unit PC may include a first transistor T1, a second transistor T2, and a storage capacitor Cst. The pixel driving circuit unit PC may be electrically connected to a signal line and a voltage line. The signal line may include a gate line such as a first scan line SL1, and a data line DL, and the voltage line may include a first voltage line VDDL.

The second transistor T2 may be electrically connected to the first scan line SL1 and the data line DL. The first scan line SL1 may provide a first scan signal GW1 to a gate electrode of the second transistor T2. The second transistor T2 may transmit a data signal Dm input from the data line DL to the first transistor T1 according to the first scan signal GW1 input from the first scan line SL1.

The storage capacitor Cst may be electrically connected to the second transistor T2 and the first voltage line VDDL and may store a voltage corresponding to a difference between a voltage received from the second transistor T2 and a first power supply voltage VDD supplied by the first voltage line VDDL.

The first transistor T1 is a driving transistor and may control driving current flowing through the light-emitting element LED. The first transistor T1 may be connected to the first voltage line VDDL and the storage capacitor Cst. The first transistor T1 may control the driving current flowing through the light-emitting element LED from the first voltage line VDDL in response to a value of the voltage stored in the storage capacitor Cst. The light-emitting element LED may emit light having a certain luminance due to the driving current. A first electrode of the light-emitting element LED may be electrically connected to the first transistor T1, and a second electrode of the light-emitting element LED may be electrically connected to a second voltage line VSSL that supplies a second power supply voltage VSS.

Although the pixel driving circuit unit PC includes two transistors and one storage capacitor in FIG. 6A, in another embodiment, the pixel driving circuit unit PC may include three or more transistors.

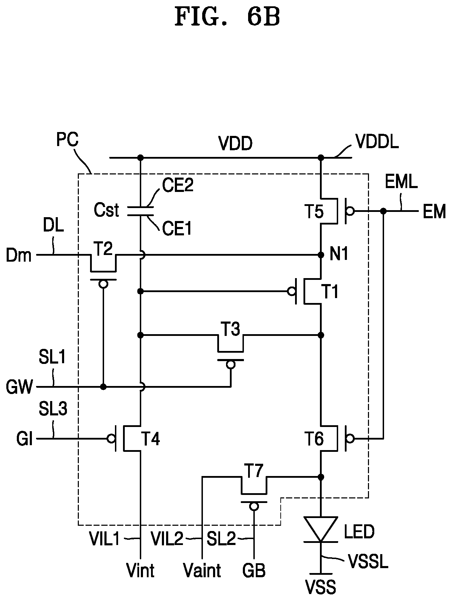

Referring to FIG. 6B, the pixel driving circuit unit PC may include a first transistor T1, a second transistor T2, a third transistor T3, a fourth transistor T4, a fifth transistor T5, a sixth transistor T6, a seventh transistor T7, and a storage capacitor Cst.

The pixel driving circuit unit PC is electrically connected to signal lines and voltage lines. The signal lines may include gate lines such as a first scan line SL1, a second scan line SL2, a third scan line SL3, a fourth scan line SL4, and an emission control line EML, and a data line DL. The voltage lines may include first and second initialization voltage lines VIL1 and VIL2, and a first voltage line VDDL.

The first voltage line VDDL may be configured to transmit a first power supply voltage VDD to the first transistor T1. The first initialization voltage line VIL1 may be configured to transmit a first initialization voltage Vint for initializing the first transistor T1 to the pixel driving circuit unit PC. The second initialization voltage line VIL2 may be configured to transmit a second initialization voltage Vaint for initializing a first electrode of the light-emitting element LED to the pixel driving circuit unit PC.

The first transistor T1 may be electrically connected to the first voltage line VDDL via the fifth transistor T5 and may be electrically connected to the light-emitting element LED via the sixth transistor T6. The first transistor T1 functions as a driving transistor, and receives a data signal Dm according to a switching operation of the second transistor T2 and supplies driving current to the light-emitting element LED.

The second transistor T2 is a data write transistor and is electrically connected to the first scan line SL1 and the data line DL. The second transistor T2 is electrically connected to the first voltage line VDDL via the fifth transistor T5. The second transistor T2 is turned on according to a first scan signal GW received through the first scan line SL1 to perform a switching operation of transmitting the data signal Dm transmitted through the data line DL to a first node N1.

The third transistor T3 is electrically connected to the first scan line SL1 and is electrically connected to the light-emitting element LED via the sixth transistor T6. The third transistor T3 may be turned on according to the first scan signal GW received through the first scan line SL1 to diode-connect the first transistor T1.

The fourth transistor T4 is a first initialization transistor and is electrically connected to the third scan line SL3 and the first initialization voltage line VIL1. The fourth transistor T4 is turned on according to a third scan signal GI received through the third scan line SL3 to initialize a voltage of a gate electrode of the first transistor T1 by transmitting the first initialization voltage Vint from the first initialization voltage line VIL1 to the gate electrode of the first transistor T1. The third scan signal GI may correspond to a first scan signal of another pixel driving circuit unit located in a previous row with respect to the pixel driving circuit unit PC.

The fifth transistor T5 may be an operation control transistor, and the sixth transistor T6 may be an emission control transistor. The fifth transistor T5 and the sixth transistor T6 are electrically connected to the emission control line EML, and are simultaneously turned on according to an emission control signal EM received through the emission control line EML to form a current path through which the driving current may flow from the first voltage line VDDL to the light-emitting element LED.

The seventh transistor T7 is a second initialization transistor and may be electrically connected to the second scan line SL2, the second initialization voltage line VIL2, and the sixth transistor T6. The seventh transistor T7 may be turned on according to a second scan signal GB received through the second scan line SL2 to initialize the first electrode of the light-emitting element LED by transmitting the second initialization voltage Vaint from the second initialization voltage line VIL2 to the first electrode of the light-emitting element LED.

The storage capacitor Cst includes a first electrode CE1 and the second electrode CE2. The first electrode CE1 is electrically connected to the gate electrode of the first transistor T1, and the second electrode CE2 is electrically connected to the first voltage line VDDL. The storage capacitor Cst may maintain a voltage applied to the gate electrode of the first transistor T1 by storing and maintaining a voltage corresponding to a voltage difference between the first voltage line VDDL and the gate electrode of the first transistor T1.

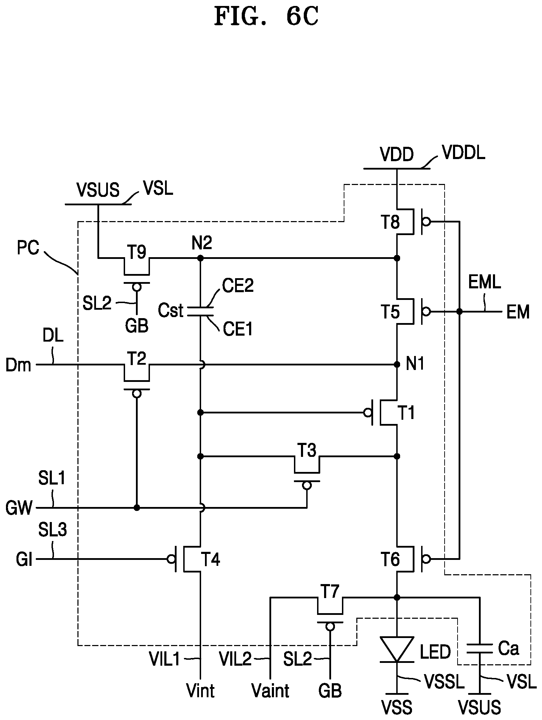

Referring to FIG. 6C, the pixel driving circuit unit PC may include a first transistor T1, a second transistor T2, a third transistor T3, a fourth transistor T4, a fifth transistor T5, a sixth transistor T6, a seventh transistor T7, an eighth transistor T8, a ninth transistor T9, a storage capacitor Cst, and an auxiliary capacitor Ca.

The pixel driving circuit unit PC is electrically connected to signal lines and voltage lines. The signal lines may include gate lines such as a first scan line SL1, a second scan line SL2, a third scan line SL3, a fourth scan line SL4, and an emission control line EML, and a data line DL. The voltage lines may include first and second initialization voltage lines VIL1 and VIL2, a sustain voltage line VSL, and a first voltage line VDDL.

The first voltage line VDDL may be configured to transmit a first power supply voltage VDD to the first transistor T1. The first initialization voltage line VIL1 may be configured to transmit a first initialization voltage Vint for initializing the first transistor T1 to the pixel driving circuit unit PC. The second initialization voltage line VIL2 may be configured to transmit a second initialization voltage Vaint for initializing a first electrode of the light-emitting element LED to the pixel driving circuit unit PC. The sustain voltage line VSL may provide a sustain voltage VSUS to a second node N2, for example, a second electrode CE2 of the storage capacitor Cst, in an initialization period and a data write period.

The first transistor T1 may be electrically connected to the first voltage line VDDL via the fifth transistor T5 and the eighth transistor T8 and may be electrically connected to the light-emitting element LED via the sixth transistor T6. The first transistor T1 functions as a driving transistor, and may supply driving current to the light-emitting element LED by receiving a data signal Dm according to a switching operation of the second transistor T2.

The second transistor T2 is electrically connected to the first scan line SL1 and the data line DL and is electrically connected to the first voltage line VDDL via the fifth transistor T5 and the eighth transistor T8. The second transistor T2 is turned on according to a first scan signal GW received through the first scan line SL1 to perform a switching operation of transmitting the data signal Dm received through the data line DL to a first node N1.

The third transistor T3 is electrically connected to the first scan line SL1 and is electrically connected to the light-emitting element LED via the sixth transistor T6. The third transistor T3 is turned on according to the first scan signal GW received through the first scan line SL1 to diode-connect the first transistor T1 and compensate for a threshold voltage of the first transistor T1.

The fourth transistor T4 is electrically connected to the third scan line SL3 and the first initialization voltage line VIL1, and is turned on according to a third scan signal GI received through the third scan line SL3 to initialize a voltage of a gate electrode of the first transistor T1 by transmitting the first initialization voltage Vint from the first initialization voltage line VIL1 to the gate electrode of the first transistor T1. The third scan signal GI may correspond to a first scan signal of another pixel driving circuit unit located in a previous row with respect to the pixel driving circuit unit PC.

The fifth transistor T5, the sixth transistor T6, and the eighth transistor T8 are electrically connected to the emission control line EML, and are simultaneously turned on according to an emission control signal EM received through the emission control line EML to form a current path through which the driving current may flow from the first voltage line VDDL to the light-emitting element LED.

The seventh transistor T7 is a second initialization transistor and may be electrically connected to the second scan line SL2, the second initialization voltage line VIL2, and the sixth transistor T6. The seventh transistor T7 is turned on according to a second scan signal GB received through the second scan line SL2 to initialize the first electrode of the light-emitting element LED by transmitting the second initialization voltage Vaint from the second initialization voltage line VIL2 to the first electrode of the light-emitting element LED.

The ninth transistor T9 may be electrically connected to the second scan line SL2, the second electrode CE2 of the storage capacitor Cst, and the sustain voltage line VSL. The ninth transistor T9 may be turned on according to the second scan signal GB received through the second scan line SL2 to transmit the sustain voltage VSUS to the second node N2, for example, the second electrode CE2 of the storage capacitor Cst, in the initialization period and the data write period.

The eighth transistor T8 and the ninth transistor T9 may be electrically connected to the second node N2, for example, the second electrode CE2 of the storage capacitor Cst. In some embodiments, the eighth transistor T8 may be turned off and the ninth transistor T9 may be turned on in the initialization period and the data write period, and the eighth transistor T8 may be turned on and the ninth transistor T9 may be turned off in an emission period. Because the sustain voltage VSUS is transmitted to the second node N2 in the initialization period and the data write period, the uniformity (e.g., long-range uniformity (LRU)) of luminance of the display apparatus according to a voltage drop of the first voltage line VDDL may be improved.

The storage capacitor Cst includes a first electrode CE1 and the second electrode CE2. The first electrode CE1 is electrically connected to the gate electrode of the first transistor T1, and the second electrode CE2 is electrically connected to the eighth transistor T8 and the ninth transistor T9.

The auxiliary capacitor Ca may be electrically connected to the sixth transistor T6, the sustain voltage line VSL, and the first electrode of the light-emitting element LED. The auxiliary capacitor Ca may store and maintain a voltage corresponding to a voltage difference between the first electrode of the light-emitting element LED and the sustain voltage line VSL while the seventh transistor T7 and the ninth transistor T9 are turned on, thereby preventing an increase in black luminance when the sixth transistor T6 is turned off.

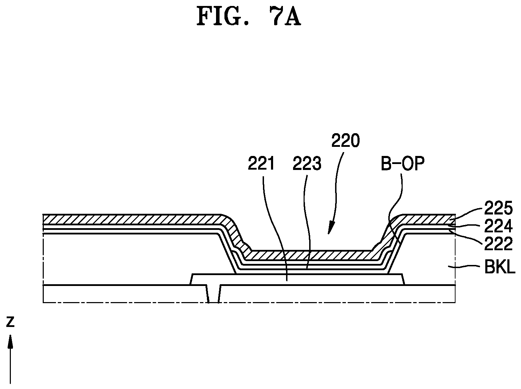

FIG. 7A is a cross-sectional view schematically illustrating a light-emitting element of a display apparatus, according to an embodiment.

Referring to FIG. 7A, a light-emitting element according to an embodiment may include an organic light-emitting diode 220 including an organic material. The organic light-emitting diode 220 may include a first electrode 221 located on an insulating layer, a second electrode 225 facing the first electrode 221, and an emission layer 223 located between the first electrode 221 and the second electrode 225. A first functional layer 222 may be located between the first electrode 221 and the emission layer 223, and a second functional layer 224 may be located between the emission layer 223 and the second electrode 225.

An edge of the first electrode 221 may be covered by a bank layer BKL including an insulating material. The bank layer BKL may include an opening B-OP overlapping a central portion of the first electrode 221.

The first electrode 221 may include a conductive oxide such as indium tin oxide (ITO), indium zinc oxide (IZO), zinc oxide (ZnO), indium oxide (In₂O₃), indium gallium oxide (IGO), or aluminum zinc oxide (AZO). In another embodiment, the first electrode 221 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a compound thereof. In another embodiment, the first electrode 221 may further include a layer formed of ITO, IZO, ZnO, AZO, or In₂O₃ over/under the reflective layer.

The emission layer 223 may include a high molecular weight organic material or a low molecular weight organic material that emits light of a certain color. The first functional layer 222 may include a hole transport layer (HTL) and/or a hole injection layer (HIL). The second functional layer 224 may include an electron transport layer (ETL) and/or an electron injection layer (EIL).

The second electrode 225 may be formed of a conductive material having a low work function. For example, the second electrode 225 may include a (semi-)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the second electrode 225 may further include a layer formed of ITO, IZO, ZnO, AZO, or In₂O₃ on the (semi-)transparent layer including the above material.

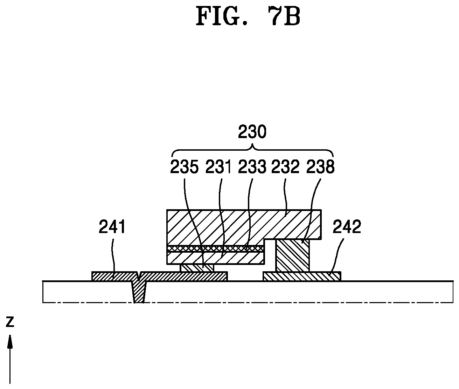

FIG. 7B is a cross-sectional view schematically illustrating a light-emitting element of a display apparatus, according to an embodiment.

Referring to FIG. 7B, a light-emitting element according to an embodiment may include an inorganic light-emitting diode 230 including an inorganic material. The inorganic light-emitting diode 230 may include a first semiconductor layer 231, a second semiconductor layer 232, an intermediate layer 233 between the first semiconductor layer 231 and the second semiconductor layer 232, a first electrode 235 electrically connected to the first semiconductor layer 231, and a second electrode 238 electrically connected to the second semiconductor layer 232. The first electrode 235 and the second electrode 238 of the inorganic light-emitting diode 230 may be electrically connected to a first electrode pad 241 and a second electrode pad 242 located on the same layer.

In some embodiments, the first semiconductor layer 231 may include a p-type semiconductor layer. The p-type semiconductor layer may be formed of a semiconductor material having a composition formula of InₓAl_{y}Ga_{1-x-y}N (0≤x≤1, 0≤y≤1, and 0≤x+y≤1) selected from among, for example, GaN, AIN, AlGaN, InGaN, InN, InAlGaN, and AllnN, and may be doped with a p-type dopant such as Mg, Zn, Ca, Sr, or Ba.

The second semiconductor layer 232 may include, for example, an n-type semiconductor layer. The n-type semiconductor layer may be formed of a semiconductor material having a composition formula of InₓAl_{y}Ga_{1-x-y}N (0≤x≤1, 0≤y≤1, and 0≤x+y≤1), selected from among, for example, GaN, AIN, AlGaN, InGaN, InN, InAlGaN, and AllnN, and may be doped with an n-type dopant such as Si, Ge, or Sn.

The intermediate layer 233 may be an area where electrons and holes recombine to change to a lower energy level and generate light having a corresponding wavelength. The intermediate layer 233 may include a semiconductor material having a composition formula of InₓAl_{y}Ga_{1-x-y}N (0≤x≤1, 0≤y≤1, and 0≤x+y≤1), and may have a single or multi-quantum well (MQW) structure. Also, the intermediate layer 233 may have a quantum wire structure or a quantum dot structure.

Although the first semiconductor layer 231 includes a p-type semiconductor layer and the second semiconductor layer 232 includes an n-type semiconductor layer in FIG. 7B, the disclosure is not limited thereto. In another embodiment, the first semiconductor layer 231 may include an n-type semiconductor layer, and the second semiconductor layer 232 may include a p-type semiconductor layer.

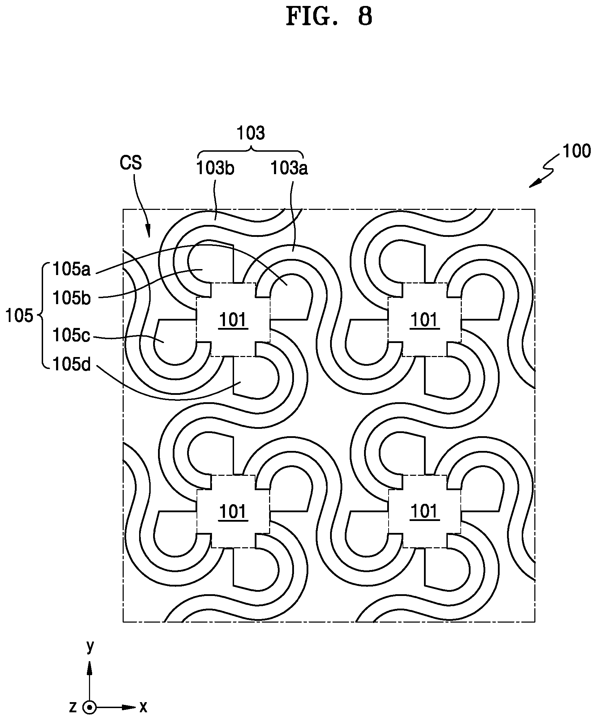

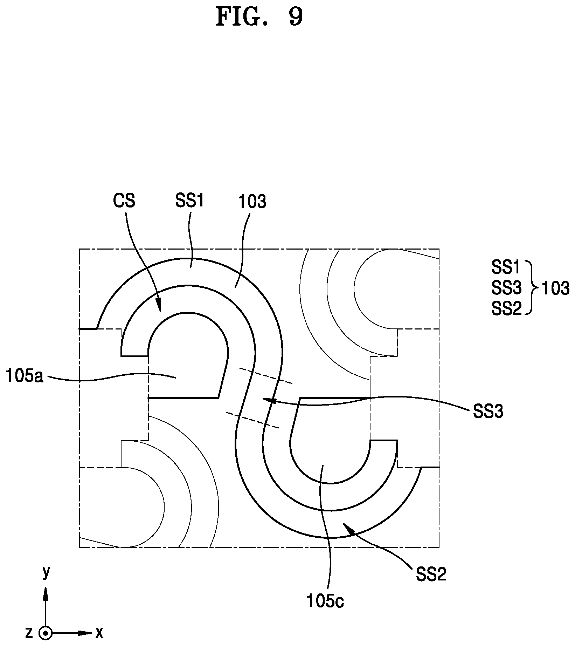

FIG. 8 is a schematic plan view illustrating a shape of a substrate applicable to a display apparatus, according to an embodiment. FIG. 9 is an enlarged plan view illustrating shapes of a bridge portion and a sub-island of a substrate applicable to a display apparatus, according to an embodiment.

Referring to FIGS. 8 and 9, the substrate 100 of the display apparatus according to the present embodiment may include base portions 101, bridge portions 103, sub-islands 105, and an opening CS. The base portions 101, the bridge portions 103, and the sub-islands 105 may be integrally formed with each other.

The base portions 101 may be arranged at certain intervals in a first direction (an x direction) and a second direction (a y direction) and may include flat top surfaces. As shown in FIG. 8, the base portions 101 may have a cross shape whose corners are recessed from a virtual square. However, the disclosure is not limited thereto. The base portions 101 may have any of various shapes such as a polygonal shape, a polygonal shape with rounded corners, a circular shape, an elliptical shape, or an irregular shape.

The base portions 101 may be connected to each other by the bridge portion 103. The bridge portion 103 may include a first bridge portion 103a connecting the base portions 101 arranged in the first direction and a second bridge portion 103b connecting the base portions 101 arranged in the second direction.

The openings CS may be empty spaces passingh through the substrate 100 from a top surface to a bottom surface of the substrate 100. The openings CS may be located between the base portions 101 and between the bridge portions 103. The opening CS may provide a separation area between the plurality of base portions 101, may reduce the weight of the substrate 100, and may improve the flexibility of the substrate 100. Also, because shapes of the openings CS are changed when the substrate 100 is curved, bent, or rolled, generation of stress during deformation of the substrate 100 may be easily reduced, thereby preventing abnormal deformation of the substrate 100 and improving durability. Accordingly, when a display apparatus 10 is used, user convenience may be improved, and in particular, the display apparatus 10 may be easily applied to a wearable device.

The opening CS may be formed by removing a portion of the substrate 100 by using etching or the like, there may be various examples of a process of forming the opening CS in the substrate 100, and there is not limitation on a manufacturing method thereof.

The sub-islands 105 may be located to surround the base portion 101. The sub-islands 105 may protrude from an outer side of the base portion 101. The sub-islands 105 may protrude from the base portion 101 toward the openings CS. The sub-islands 105 may be located in a space between the base portion 101 and the bridge portion 103.

One end of the sub-islands 105 may be connected to the base portion 101, and the other end may contact the opening CS without being connected to another member. That is, the opening CS may be located around the sub-islands 105. At least a part of the sub-island 105 may be surrounded by the opening CS.

There may be a plurality of sub-islands 105 connected to one base portion 101. For example, there may be two to four sub-islands 105 connected to one base portion 101.

In some embodiments, the sub-island 105 may include a first sub-island 105a, a second sub-island 105b, a third sub-island 105c, and a fourth sub-island 105d.

The first sub-island 105a may be connected to a right side of the base portion 101. The first sub-island 105a may be an area protruding from the base portion 101 in the first direction (the x direction). The second sub-island 105b may be connected to an upper side of the base portion 101. The second sub-island 105b may be an area protruding from the base portion 101 in the second direction (the y direction).

The third sub-island 105c may be connected to a left side of the base portion 101. The third sub-island 105c may be an area protruding from the base portion 101 in a direction (a -x direction) opposite to the first direction. The fourth sub-island 105d may be connected to a lower side of the base portion 101. The fourth sub-island 105d may be an area protruding from the base portion 101 in a direction (a -y direction) opposite to the second direction.

In some embodiments, the area of each of the first sub-island 105a, the second sub-island 105b, the third sub-island 105c, and the fourth sub-island 105d may be less than the area of the connected base portion 101. However, the disclosure is not limited thereto. Various modifications may be made. For example, the area of each of the of the first sub-island 105a, the second sub-island 105b, the third sub-island 105c, and the fourth sub-island 105d may be the same as or greater than the area of the connected base portion 101.

Referring to FIG. 9, the bridge portion 103 may include a first portion SS1 convexly curved toward a third direction in an xy plane and a second portion SS2 connected to the first portion SS1 and convexly curved toward a fourth direction opposite to the third direction in the same plane. The first portion SS1 and the second portion SS2 may be bent portions in a plan view. The third direction and the fourth direction may be directions intersecting the x direction or the y direction. However, the disclosure is not limited thereto. The third direction and the fourth direction may be directions parallel to the x direction or the y direction.

A third portion SS3 that connects the first portion SS1 to the second portion SS2 of the bridge portion 103 may be located between the first portion SS1 and the second portion SS2 of the bridge portion 103, and the third portion SS3 may correspond to an inflection point of the bridge portion 103. The third portion SS3 may be a straight portion that is not bent in a plan view. The third portion SS3 may be an area having a smaller strain than the first portion SS1 and the second portion SS2. The first portion SS1, the second portion SS2, and the third portion SS3 may be continuously provided. The bridge portion 103 may have an S-shape when viewed as a whole.

The first portion SS1 and the second portion SS2 are areas subjected to strain, and radii of curvature of each of the first portion SS1 and the second portion SS2 may be designed to be large in order to minimize strain. Accordingly, a space occupied by the bridge portion 103 may increase and a space occupied by the base portion 101 may relatively decrease.

In the present embodiment, by introducing the sub-islands 105 connected to the base portion 101, a space where a light-emitting element and/or pixel driving circuit units may be located may be secured.

The sub-island 105 may be located between the base portion 101 and the bridge portion 103, and at least a part of the sub-island 105 may correspond to a shape of the bridge portion 103. That is, at least a part of an outer side of the sub-island 105 may have a radius of curvature corresponding to the first portion SS1 of the bridge portion 103. The opening CS may be provided between the sub-island 105 and the bridge portion 103, and at least a part of the opening CS may be provided at a certain interval.

Shapes of a plurality of bridge portions 103 may be changed and lengths of the plurality of bridge portions 103 may be increased or reduce due to an external force and when the external force is removed, the plurality of connecting units 103 may return to their original shapes. In detail, a length of the bridge portion 103 may be increased when the first portion SS1 and the second portion SS2 are unfolded, or a length of the bridge portion 103 may be reduced when the first portion SS1 and the second portion SS2 are contracted. Accordingly, an interval between a plurality of base portions 101 may be changed by the plurality of bridge portions 103, and thus, a shape of the substrate 100 may be two-dimensionally or three-dimensionally changed.

Also, because the opening CS that is an empty space is formed between the plurality of bridge portions 103, the substrate 100 may have a mesh pattern, and thus, the substrate 100 may be highly flexible.

A plurality of sub-islands 105 may be areas that are not directly connected to the bridge portions 103 and thus are hardly deformed by an external force. Also, the plurality of sub-islands 105 may be areas having smallest strain.

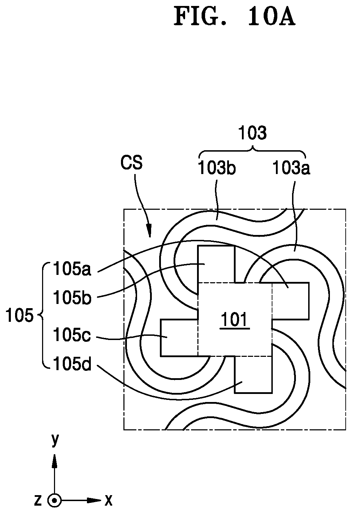

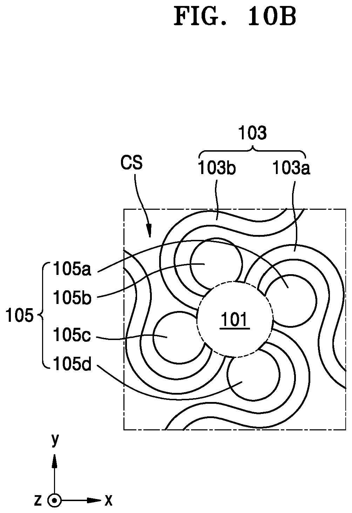

FIGS. 10A and 10B are schematic plan views illustrating a shape of a substrate applicable to a display apparatus, according to an embodiment.

Referring to FIGS. 10A and 10B, the substrate 100 according to the present embodiment may include the base portions 101, the bridge portions 103, the sub-islands 105, and the opening CS. The base portions 101, the bridge portions 103, and the sub-islands 105 may be integrally formed with each other. The opening CS may be located between the base portions 101 and between the bridge portions 103.

The base portion 101 and the sub-island 105 may have various shapes. FIGS. 10A and 10B illustrate modified embodiments of shapes of the base portion 101 and the sub-island 105.

As shown in FIG. 10A, each of the base portion 101 and the sub-island 105 may have a quadrangular shape. As shown in FIG. 10B, the base portion 101 may have a circular shape, and at least a part of each of the sub-islands 105 may have a circular shape.

The sub-islands 105a may include the first sub-island 105a, the second sub-island 105b, the third sub-island 105c, and the fourth sub-island 105d protruding from an outer side of the base portion 101. Ends of the sub-islands 105 may contact the opening CS, and at least a part of each of the sub-islands 105 may be surrounded by the opening CS.

The sub-islands 105 and the bridge portions 103 may alternately surround the base portion 101. That is, in a counterclockwise direction from an outer side of the base portion 101, the first sub-island 105a, the first bridge portion 103a extending in the +x direction, the second sub-island 105b, the second bridge portion 103b extending in the +y direction, the third sub-island 105c, the first bridge portion 103a extending in the -x direction, the fourth sub-island 105d, and the second bridge portion 103b extending in the -y direction may be arranged.

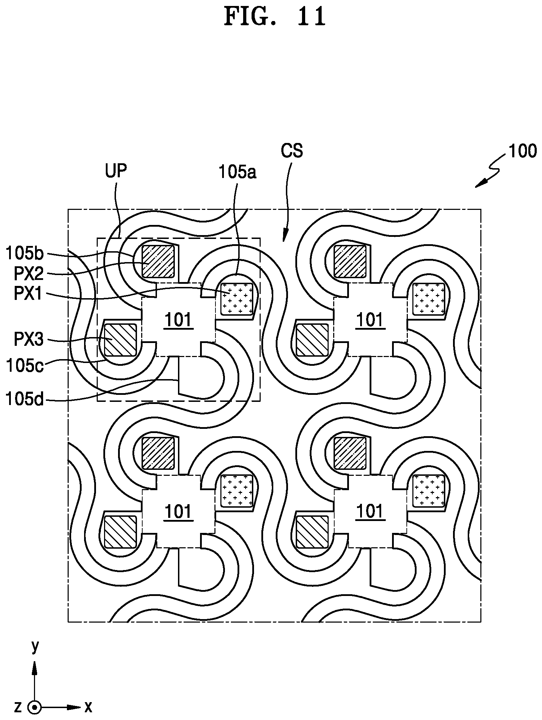

FIG. 11 is a plan view schematically illustrating a pixel arrangement or light-emitting element arrangement structure of a display apparatus, according to an embodiment.

Referring to FIG. 11, in a display apparatus, a plurality of unit pixels UP may be repeatedly arranged in the x direction and the y direction. The unit pixel UP may include a first sub-pixel PX1, a second sub-pixel PX2, and a third sub-pixel PX3 emitting light of different colors. The first sub-pixel PX1, the second sub-pixel PX2, and the third sub-pixel PX3 may be respectively red, green, and blue pixels.

The first sub-pixel PX1 may be located on the first sub-island 105a. The first sub-pixel PX1 may be implemented by a first light-emitting element. The first light-emitting element may be located on the first sub-island 105a.

The second sub-pixel PX2 may be located on the second sub-island 105b. The second sub-pixel PX2 may be implemented by a second light-emitting element. The second light-emitting element may be located on the second sub-island 105b.

The third sub-pixel PX3 may be located on the third sub-island 105c. The third sub-pixel PX3 may be implemented by a third light-emitting element. The third light-emitting element may be located on the third sub-island 105c.

The first sub-pixel PX1, the second sub-pixel PX2, and the third sub-pixel PX3 may be located at vertices of a virtual triangle. The virtual triangle may be an isosceles triangle. An interval between the center of the first sub-pixel PX1 and the center of the second sub-pixel PX2 may be the same as an interval between the center of the second sub-pixel PX2 and the center of the third sub-pixel PX3. An interval between the center of the first sub-pixel PX1 and the center of the third sub-pixel PX3 may be greater than an interval between the center of the first sub-pixel PX1 and the center of the second sub-pixel PX2. The first sub-pixel PX1, the second sub-pixel PX2, and the third sub-pixel PX3 may form a group to implement one unit pixel UP.

In some embodiments, a light-emitting element may not be located on the fourth sub-island 105d.

In the present embodiment, because the first sub-pixel PX1, the second sub-pixel PX2, and the third sub-pixel PX3 are not located on the base portion 101 but are located on the first sub-island 105a, the second sub-island 105b, and the second sub-island 105b, the display apparatus receives minimal strain when stretched or contracted, thereby ensuring reliability.

Also, according to embodiments, because the first sub-pixel PX1, the second sub-pixel PX2, and the third sub-pixel PX3 are distributed, aperture ratios visibility of the first sub-pixel PX1, the second sub-pixel PX2, and the third sub-pixel PX3 may be improved.

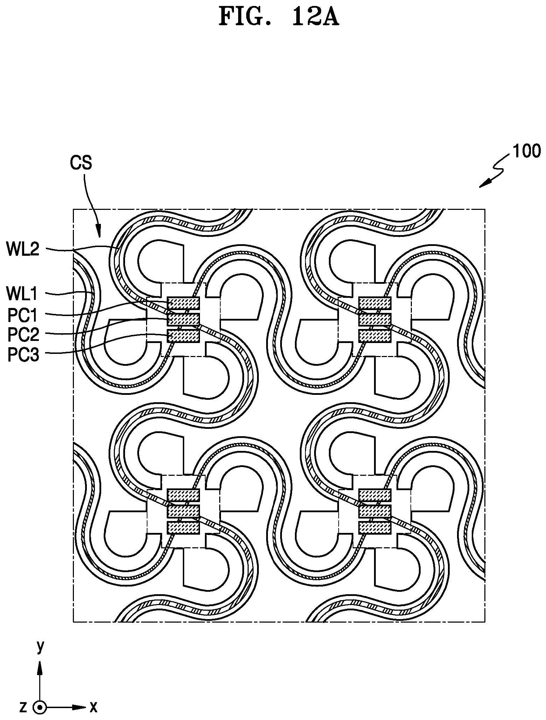

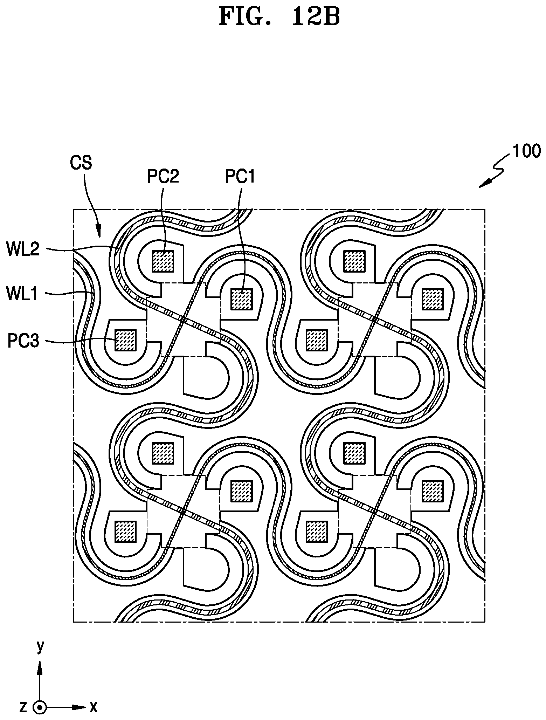

FIGS. 12A and 12B are plan views illustrating an arrangement of pixel driving circuit units and an arrangement of wirings of a display apparatus, according to embodiments. In FIGS. 12A and 12B, only some elements are shown for convenience of explanation.

Referring to FIG. 12A, a first pixel driving circuit unit PC1, a second pixel driving circuit unit PC2, and a third pixel driving circuit unit PC3 may be located on the base portion 101.

A first wiring WL1 may be located on the first bridge portion 103a and may be electrically connected to the first pixel driving circuit unit PC1, the second pixel driving circuit unit PC2, and the third pixel circuit driving unit PC3. The first wiring WL1 that is a signal line such as a scan line or an emission control line may provide a scan signal or an emission control signal to the first pixel driving circuit unit PC1, the second pixel driving circuit unit PC2, and the third pixel driving circuit unit PC3.

The first wiring WL1 may extend in the first direction and may be curved along a shape of the first bridge portion 103a. The first wiring WL1 may include at least two curved portions on the first bridge portion 103a. The first wiring WL1 may be continuously located in the first bridge portion 103a and the base portion 101.

A second wiring WL2 may be located on the second bridge portion 103b and may be electrically connected to the first pixel driving circuit unit PC1, the second pixel driving circuit unit PC2, and the third pixel driving circuit unit PC3. The second wiring WL2 that is a data line may provide a data signal to the first pixel driving circuit unit PC1, the second pixel driving circuit unit PC2, and the third pixel driving circuit unit PC3.

The second wiring WL2 may extend in the second direction and may be curved along a shape of a second bridge portion 103b. The second wiring WL2 may include at least two curved portions on the second bridge portion 103b. The second wiring WL2 may be continuously located in the second bridge portion 103b and the base portion 101.

The first wiring WL1 and the second wiring WL2 may be located on the same layer in the first bridge portion 103a and the second bridge portion 103b and may be located on different layers in the base portion 101. The first wiring WL1 and the second wiring WL2 may be provided as a combination of wirings located on different layers. The first wiring WL1 and the second wiring WL2 may intersect each other in the base portion 101.

The first pixel driving circuit unit PC1 may be a pixel driving circuit unit for driving a first light-emitting element implementing the first sub-pixel PX1 (see FIG. 11). Because the first light-emitting element is located on the first sub-island 105a, the first pixel driving circuit unit PC1 may be connected to the first light-emitting element by a first connection wiring (not shown).

The second pixel driving circuit unit PC2 may be a pixel driving circuit unit for driving a second light-emitting element implementing the second sub-pixel PX2 (see FIG. 11). Because the second light-emitting element is located on the second sub-island 105b, the second pixel driving circuit unit PC2 may be connected to the second light-emitting element by a second connection wiring (not shown).

The third pixel driving circuit unit PC3 may be a pixel driving circuit unit for driving a third light-emitting element implementing the third sub-pixel PX3 (see FIG. 11). Because the third light-emitting element is located on the third sub-island 105c, the third pixel driving circuit unit PC3 may be connected to the third light-emitting element by a third connection wiring (not shown).

Although the first pixel driving circuit unit PC1, the second pixel driving circuit unit PC2, and the third pixel driving circuit unit PC3 are located on the base portion 101 in FIG. 12A, the disclosure is not limited thereto. As shown in FIG. 12B, the first pixel driving circuit unit PC1, the second pixel driving circuit unit PC2, and the third pixel driving circuit unit PC3 may be respectively located on the sub-islands 105.

For example, the first pixel driving circuit unit PC1, the second pixel driving circuit unit PC2, and the third pixel driving circuit unit PC3 may be respectively located on the first sub-island 105a, the second sub-island 105b, and the third sub-island 105c. The first pixel driving circuit unit PC1, the second pixel driving circuit unit PC2, and the third pixel driving circuit unit PC3 may be electrically connected to the first wiring WL1 and the second wiring WL2. Accordingly, the first pixel driving circuit unit PC1, the second pixel driving circuit unit PC2, and the third pixel driving circuit unit PC3 may be connected to the first wiring WL1 and the second wiring WL2 by connection wirings (not shown).

The first sub-pixel PX1 (see FIG. 11) may overlap the first pixel driving circuit unit PC1. The second sub-pixel PX2 (see FIG. 11) may overlap the second pixel driving circuit unit PC2. The third sub-pixel PX3 (see FIG. 11) may overlap the third pixel driving circuit unit PC3.

However, the disclosure is not limited thereto. Various modifications may be made. For example, unlike in FIGS. 12A and 12B, at least one of the first pixel driving circuit unit PC1, the second pixel driving circuit unit PC2, and the third pixel driving circuit unit PC3 may be located on the base portion 101 and the rest may be located on the sub-islands 105.

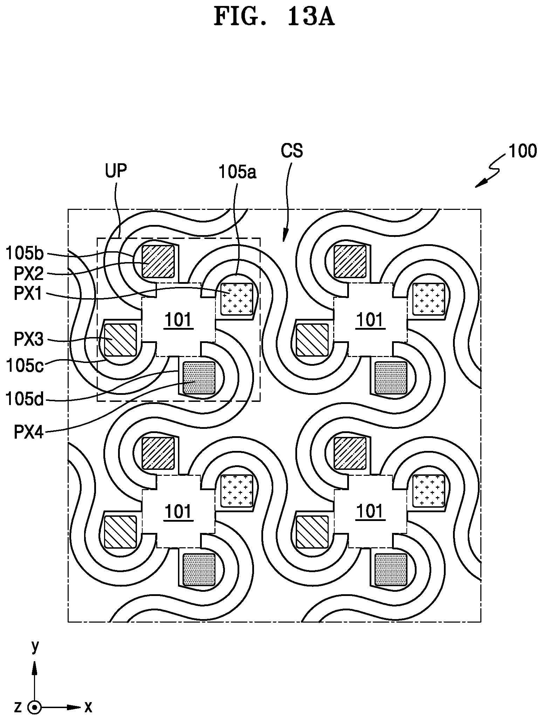

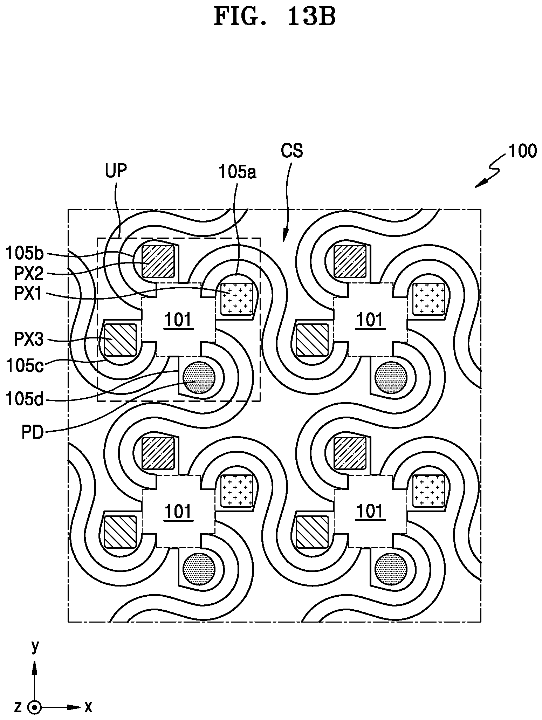

FIGS. 13A and 13B are plan views schematically illustrating a pixel arrangement or light-emitting element arrangement structure of a display apparatus, according to an embodiment. In FIGS. 13A and 13B, the same members as those in FIG. 11 are denoted by the same reference numerals.

Referring to FIGS. 13A and 13B, in a display apparatus, a plurality of unit pixels UP may be repeatedly arranged in the x direction and the y direction. The unit pixel UP may include a first sub-pixel PX1, a second sub-pixel PX2, and a third sub-pixel PX3 emitting light of different colors. The first sub-pixel PX1, the second sub-pixel PX2, and the third sub-pixel PX3 may be respectively red, green, and blue pixels.

Referring to FIG. 13A, the unit pixel UP may further include a fourth sub-pixel PX4. In some embodiments, the fourth sub-pixel PX4 may be a red, green, blue, or white pixel. Various modifications may be made. For example, a color of the fourth sub-pixel PX4 may be the same or different for each unit pixel UP. The fourth sub-pixel PX4 may be located on the fourth sub-island 105d. As the fourth sub-pixel PX4 is located, the visibility of the display apparatus may be improved.

In some embodiments, when a light-emitting element is an organic light-emitting diode, the fourth sub-pixel PX4 may be a green pixel. In this case, the unit pixel UP may include two green pixels, one red pixel, and one blue pixel.

In an embodiment, when a light-emitting element is an inorganic light-emitting diode, the fourth sub-pixel PX4 may be a red pixel. In this case, the unit pixel UP may include two red pixels, one green pixel, and one blue pixel.

Referring to FIG. 13B, the unit pixel UP may further include a sensor PD. In some embodiments, the sensor PD may be a light sensor. For example, the sensor PD may be a visible light (VIS) sensor or an infrared light (IR) sensor. The VIS sensor may recognize an image by detecting visible light reflected from an image such as a photo or a barcode. The IR sensor may recognize a touch by detecting infrared light reflected by a touch of a finger or the like. The sensor PD may be provided as a photodiode. In some embodiments, the sensor PD may be included in only some unit pixels UP of the display apparatus.

The display apparatus 1 according to the above embodiments may be used in various electronic devices capable of providing an image. The term "electronic device" refers to a device capable of providing a certain image by using electricity.

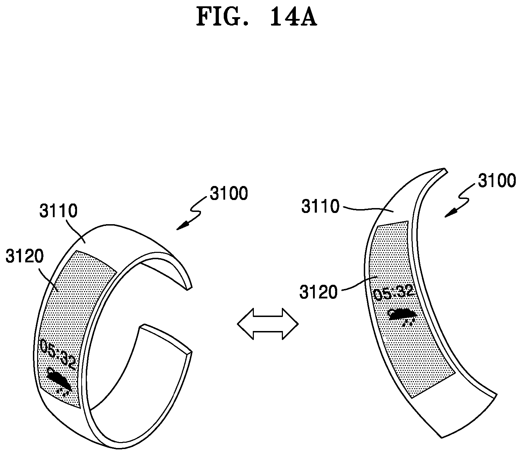

FIGS. 14A to 14G are perspective views schematically illustrating embodiments of an electronic device including a display apparatus, according to an embodiment.

Referring to FIG. 14A, a display apparatus according to an embodiment may be used in a wearable electronic device 3100 that may be worn on a user's body part. The wearable electronic device 3100 may include a body portion 3110 and a display unit 3120 provided on the body portion 3110. A display apparatus according to embodiments may be used as the display unit 3120 of the wearable electronic device 3100. As shown in FIG. 14A, the wearable electronic device 3100 may be deformable. In an embodiment, the wearable electronic device 3100 may be used as a smart watch or a smartphone according to a user's selection.

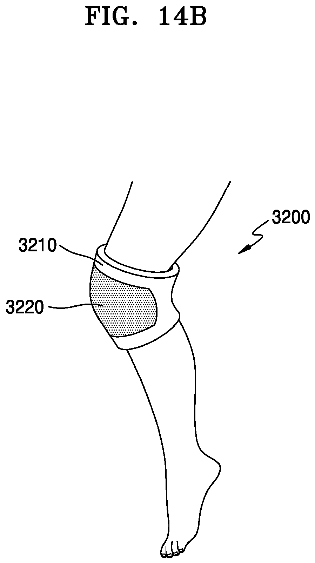

FIG. 14B illustrates a medical electronic device 3200. In an embodiment, the medical electronic device 3200 may include a body portion 3210 and a light-emitting unit 3220. A display apparatus according to embodiments may be used as the light-emitting unit 3220 of the medical electronic device 3200. The light-emitting unit 3220 may emit light of a certain wavelength band (e.g., infrared light or visible light) to a patient's body. In an embodiment, the body portion 3210 may include a stretchable fiber material, and may have a structure that may be worn on a user's body.

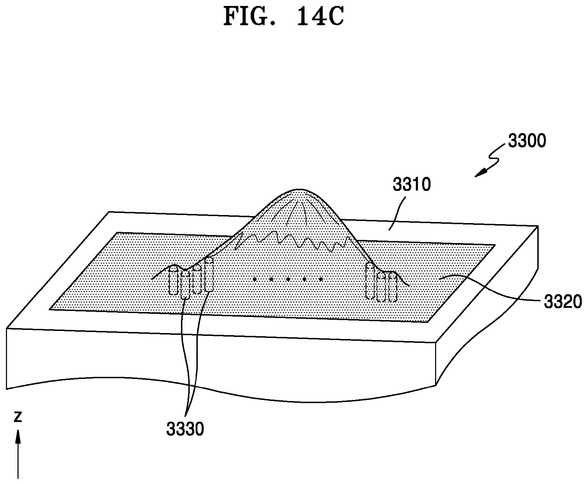

FIG. 14C illustrates an educational electronic device 3300. In an embodiment, the educational electronic device may include a display unit 3320 provided in a frame 3310. The display unit 3320 may use a display apparatus according to embodiments. An image such as a sea with waves, a snow-covered mountain, or a volcano through which lava flows may be provided through the display unit 3320, and in this case, the display unit 3320 may be stretched in a height direction (e.g., the z direction) by reflecting the height of the waves, mountain, or volcano. In some embodiments, a part of the display unit 3320 may be sequentially changed in height along a direction in which the lava flows to three-dimensionally show the movement of the lava. The educational electronic device 3300 may include a plurality of pins (or stroke units 3330) located on a rear surface of the display unit 3320 so that the display unit 3320 is stretched in the height direction. As the pins 3330 move along the third direction (e.g., the z direction or the -z direction), an image displayed on the display unit 3320 may be implemented to have a three-dimensional height. Although the educational electronic device 3300 is described with reference to FIG. 14C, its use is not limited as long as certain image information is provided.

Although an electronic device as shown in FIGS. 14A to 14C is an electronic device whose shape is variable, the disclosure is not limited thereto. As in embodiments described below, a display apparatus according to embodiments may be used in an electronic device in which a portion for displaying an image (e.g., a screen) is fixed.

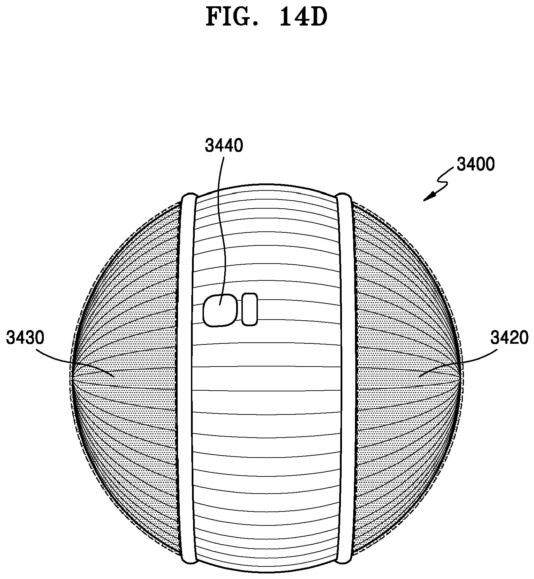

FIG. 14D illustrates a robot 3400 as an electronic device, according to an embodiment. The robot 3400 may recognize movement or an object by using a camera unit 3440, and may display a certain image to a user through display units 3420 and 3430. In some embodiments, because display apparatuses according to an embodiment may be stretched in various directions as described above, the display apparatuses may be assembled into a body frame having a hemispherical shape, and thus, the robot 3400 may include the display units 3420 and 3430 each having a hemispherical shape.

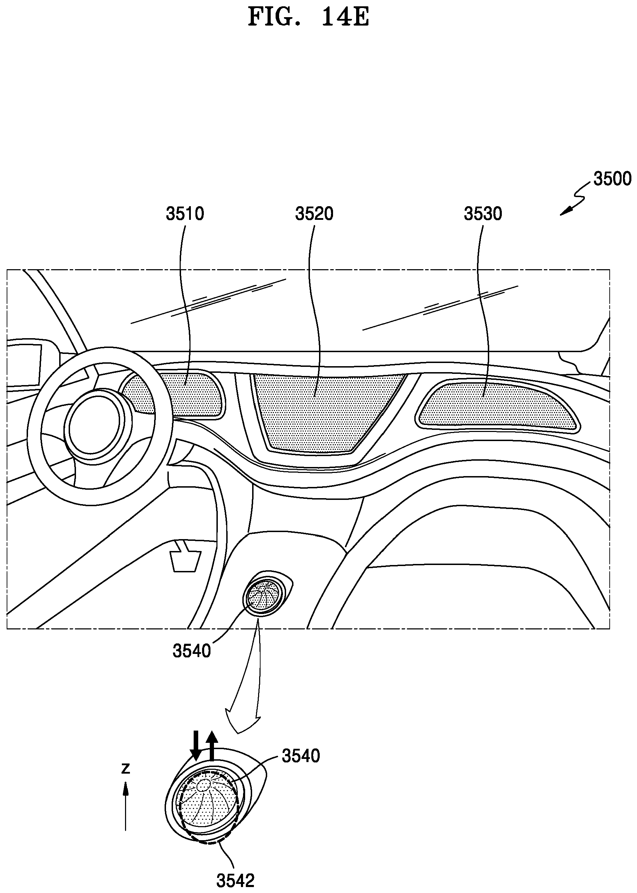

FIG. 14E illustrates a display device 3500 for a vehicle as an electronic device, according to an embodiment. The display device 3500 for a vehicle may include a cluster 3510, a center information display (CID) 3520, and/or a passenger display (co-driver display). Because a display apparatus according to an embodiment may be stretched in various directions, the display apparatus may be used in the cluster 3510, the CID 3520, and/or the co-driver display regardless of a shape of an internal frame of a vehicle.

Although the cluster 3510, the CID 3520, and/or the co-driver display are separated from each other in FIG. 14E, the disclosure is not limited thereto. In another embodiment, two or more selected from the cluster 3510, the CID 3520, and the co-driver display may be integrally connected.

In some embodiments, the display device 3500 for a vehicle may include a button 3540 for displaying a certain image. Referring to an enlarged view of FIG. 14E, the button 3540 having a hemispherical shape may include an object 3542 that provides a feeling of using the button while moving in the z direction or the -z direction, and a display apparatus located on the object 3542. In some embodiments, when the object 3542 has a three-dimensionally rounded surface, the display apparatus may also have a three-dimensionally rounded surface.

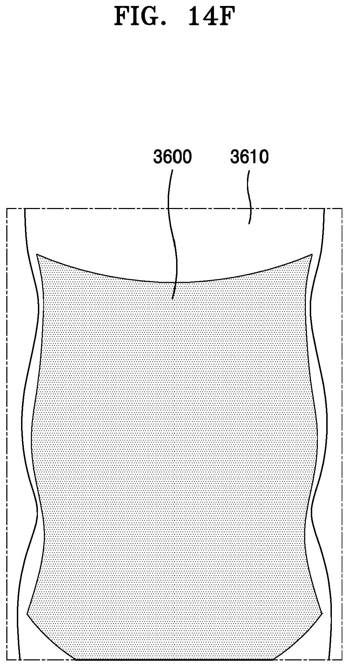

FIG. 14F illustrates an electronic device 3600 for advertisement or exhibition as an electronic device, according to an embodiment. In some embodiments, the electronic device 3600 for advertisement or exhibition may be installed on a fixed structure 3610 such as a wall or a pillar. When the structure 3610 includes an uneven surface as shown in FIG. 14F, the electronic device 3600 for advertisement or exhibition may be located along the uneven surface of the structure 3610. In some embodiments, the electronic device 3600 for advertisement or exhibition may be installed on the structure 3610 by using a heat shrink film or the like.

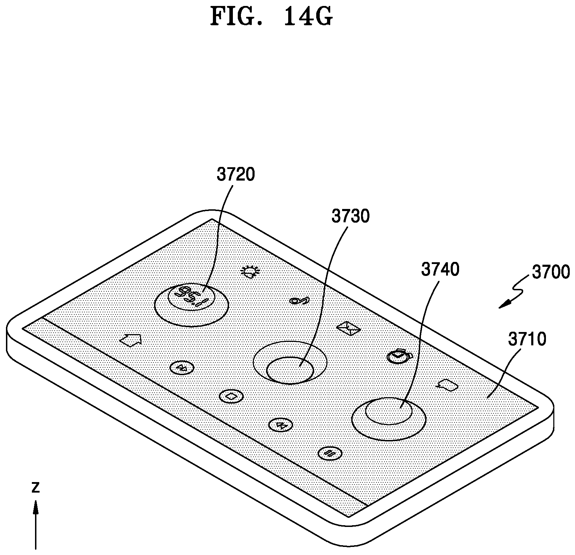

FIG. 14G illustrates a controller 3700 as an electronic device, according to an embodiment. The controller 3700 may include an image-type button. For example, a display unit 3710 of the controller 3700 may include first to third button areas 3720, 3730, and 3740 protruding in the z direction or protruding in the -z direction (or recessed in the z direction). In some embodiments, the first and third button areas 3720 and 3740 may protrude in the z direction, and the second button area 3730 may protrude in the -z direction (or be recessed in the z direction).

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by one of ordinary skill in the art that various changes in form and details may be made therein without departing from the spirit and scope as defined by the following claims.

## Claims

1. A display apparatus comprising:
a substrate comprising base portions arranged in a first direction and a second direction, a first bridge portion connecting the base portions arranged in the first direction, a second bridge portion connecting the base portions arranged in the second direction, openings located between the base portions, and sub-islands protruding from the base portions;
a first wiring located on the first bridge portion;
a second wiring located on the second bridge portion; and
a light-emitting element located on each of the sub-islands.

2. The display apparatus of claim 1, wherein an area of one of the sub-islands is less than an area of one of the base portions.

3. The display apparatus of claim 1, wherein each of the first bridge portion and the second bridge portion has an S shape.

4. The display apparatus of claim 1, wherein the first bridge portion comprises a first portion convex in one direction in a plan view and a second portion convex in a direction opposite to the first portion,
wherein an outer side of a first sub-island from among the sub-islands has a radius of curvature corresponding to the first portion.

5. The display apparatus of claim 1, wherein the sub-islands are connected to one base portion and comprise a first sub-island, a second sub-island, a third sub-island, and a fourth sub-island which are spaced apart from each other,
wherein a first sub-pixel is located on the first sub-island, a second sub-pixel is located on the second sub-island, and a third sub-pixel is located on the third sub-island,
wherein the first sub-pixel, the second sub-pixel, and the third sub-pixel emit light of different colors.

6. The display apparatus of claim 5, further comprising:
a first pixel driving circuit unit located on the base portion to drive the first sub-pixel;
a second pixel driving circuit unit located on the base portion to drive the second sub-pixel; and
a third pixel driving circuit unit located on the base portion to drive the third sub-pixel.

7. The display apparatus of claim 5, further comprising:
a first pixel driving circuit unit located on the first sub-island;
a second pixel driving circuit unit located on the second sub-island; and
a third pixel driving circuit unit located on the third sub-island.

8. The display apparatus of claim 5, wherein a fourth sub-pixel is located on the fourth sub-island, and the fourth sub-pixel emits light of a same color as one of the first sub-pixel, the second sub-pixel, and the third sub-pixel.

9. The display apparatus of claim 5, wherein a sensor is located on the fourth sub-island, and the sensor is a light sensor.

10. The display apparatus of claim 1, wherein the first wiring and the second wiring intersect each other in the base portion.

11. A display apparatus comprising:
a substrate comprising a base portion, bridge portions connected to the base portion, sub-islands, and an opening located around the sub-islands; wirings located on the bridge portions; and
light-emitting elements located on the sub-islands,
wherein the bridge portions and the sub-islands surround an outer side of the base portion and are alternately connected to each other.

12. The display apparatus of claim 11, wherein the bridge portions comprise a first bridge portion extending in a first direction and a second bridge portion in a second direction.

13. The display apparatus of claim 12, wherein a first wiring is located on the first bridge portion, and a second wiring is located on the second bridge portion,
wherein the first wiring and the second wiring intersect each other in the base portion.

14. The display apparatus of claim 11, wherein an area of one of the sub-islands is less than an area of one of the base portions.

15. The display apparatus of claim 11, wherein each of the bridge portions has an S shape.

16. The display apparatus of claim 11, wherein the sub-islands are connected to one base portion and comprise a first sub-island, a second sub-island, a third sub-island, and a fourth sub-island which are spaced apart from each other,
wherein a first sub-pixel is located on the first sub-island, a second sub-pixel is located on the second sub-island, and a third sub-pixel is located on the third sub-island,
wherein the first sub-pixel, the second sub-pixel, and the third sub-pixel emit light of different colors.

17. The display apparatus of claim 16, further comprising:
a first pixel driving circuit unit located on the base portion to drive the first sub-pixel;
a second pixel driving circuit unit located on the base portion to drive the second sub-pixel; and
a third pixel driving circuit unit located on the base portion to drive the third sub-pixel.

18. The display apparatus of claim 16, further comprising:
a first pixel driving circuit unit located on the first sub-island;
a second pixel driving circuit unit located on the second sub-island; and
a third pixel driving circuit unit located on the third sub-island.

19. The display apparatus of claim 16, wherein a fourth sub-pixel is located on the fourth sub-island, and the fourth sub-pixel emits light of a same color as one of the first sub-pixel, the second sub-pixel, and the third sub-pixel.

20. The display apparatus of claim 16, wherein a sensor is located on the fourth sub-island, and the sensor is a light sensor.
